# FASCICULE DE BREVET EUROPEEN

(11) **EP 3 596 003 B1**
(45) Date de publication et mention de la délivrance du brevet: **15.01.2025**
(21) Numéro de dépôt: 18714305.2
(22) Date de dépôt: 14.03.2018
(51) Int. Cl.: B81B 5/00, B81B 3/00

(54) **MICRO-DISPOSITIF COMPRENANT AU MOINS DEUX ELEMENTS MOBILES**
MIKROVORRICHTUNG MIT MINDESTENS ZWEI BEWEGLICHEN ELEMENTEN
MICRODEVICE COMPRISING AT LEAST TWO MOVABLE ELEMENTS

(30) Priorité: 16.03.2017 FR 1752155
(43) Date de publication de la demande: 22.01.2020
(73) Titulaire: Commissariat à l'Energie Atomique et aux Energies Alternatives, 75015 Paris (FR); Safran, 75015 Paris (FR)
(72) Inventeur: BERTHELOT, Audrey, 38330 Saint-Ismier (FR); COLIN, Mikaël, 38000 Grenoble (FR); JEANROY, Alain, 77550 Moissy-Cramayel (FR); LEHEE, Guillaume, 77550 Moissy-Cramayel (FR); VANCAUWENBERGHE, Olivier, 77550 Moissy-Cramayel (FR); ONFROY, Philippe, 77550 Moissy-Cramayel (FR); MACE, Jean-Sébastien, 77550 Moissy-Cramayel (FR)
(74) Mandataire: Brevalex
(86) Numéro de dépôt international: PCT/FR2018/050597
(87) Numéro de publication internationale: WO 2018/172661

(56) Documents cités:
- FR-A1- 3 013 441
- US-A1- 2010 257 934
- LANGFELDER GIACOMO ET AL: "Analysis of Mode-Split Operation in MEMS Based on Piezoresistive Nanogauges", JOURNAL OF MICROELECTROMECHANICAL SYSTEMS, IEEE SERVICE CENTER, US, vol. 24, no. 1, 1 February 2015 (2015-02-01), pages 174 - 181, XP011571915, ISSN: 1057-7157, [retrieved on 20150130], DOI: 10.1109/JMEMS.2014.2324032

## Description

### DOMAINE TECHNIQUE ET ART ANTÉRIEUR

L'invention concerne le domaine des micro-dispositifs, notamment celui des micro-dispositifs de type microsystèmes électromécaniques (MEMS) et/ou nanosystèmes électromécaniques (NEMS) et/ou microsystèmes opto-électromécaniques (MOEMS) et/ou nanosystèmes opto-électromécaniques (NOEMS), comportant des éléments mobiles aptes à se déplacer sous l'effet d'une action extérieure (mécanique, électrique, magnétique) par rapport à une partie fixe du dispositif. Par la suite, le terme « micro-dispositif » est utilisé pour désigner en particulier un dispositif de type MEMS et/ou NEMS et/ou MOEMS et/ou NOEMS.

Les micro-dispositifs sont généralement réalisés par la mise en œuvre de techniques classiques de gravure collective d'une plaque de matériau semi-conducteur (par exemple de silicium). Ils sont petits et peu coûteux à fabriquer. Les domaines d'applications peuvent être très variés, allant des produits grands publics jusqu'à des domaines d'applications très spécifiques.

Certains micro-dispositifs comportent chacun plusieurs éléments mobiles, comme par exemple certains capteurs inertiels qui nécessitent plusieurs masses mobiles pour réaliser des mesures inertielles. Un des domaines d'application de ces capteurs est par exemple la mesure inertielle de grandeurs angulaires telles que la position angulaire (gyroscopes) et la vitesse de rotation (gyromètres). Les performances d'un tel capteur inertiel dépendent directement de l'équilibrage du résonateur, et plus particulièrement de l'équilibrage entre les différentes masses mobiles du capteur. Ceci nécessite la présence d'au moins deux masses mobiles montées symétriquement l'une par rapport à l'autre de telle manière qu'elles puissent se déplacer en opposition de phase l'une par rapport à l'autre, procurant ainsi un équilibrage du capteur.

Ces masses mobiles peuvent être réalisées côte à côte au sein d'une même couche de matériau, comme cela est décrit dans les documents US2014/0299947A1 et EP 2 887 013 A1. Toutefois, un tel capteur de grandeur angulaire comprenant deux masses mobiles disposées côte à côte et réalisées dans une même couche de matériau a pour inconvénient d'engendrer un balourd dynamique résultant du déplacement du centre de gravité global des masses mobiles à leur fréquence de vibration. Cela provoque des forces de réaction dans le support et donc une perte d'énergie de la vibration. De plus, la présence des masses mobiles côte à côte implique, pour le capteur, des dimensions importantes et donc un coût de réalisation important.

De manière alternative, il est également connu de réaliser, au sein d'une même couche de matériau, des masses mobiles concentriques. La présence d'au moins deux masses mobiles concentriques réalisées dans une même couche a toutefois pour défaut principal que ces deux masses ne peuvent pas avoir des formes identiques. Cette configuration peut engendrer des problèmes d'équilibrage de ces masses. De plus, la réalisation concentrique de ces masses mobiles implique, pour le capteur, des dimensions importantes, et donc un coût de réalisation important. Ces importantes dimensions se retrouvent également même lorsqu'une seule masse mobile est réalisée dans une seule couche de matériau.

Une autre configuration consiste à réaliser les deux masses mobiles d'un capteur l'une au-dessus de l'autre, chacune au sein d'une couche de matériau différente. Cette configuration permet d'éviter les problèmes rencontrés avec les configurations décrites ci-dessus dans lesquelles les masses mobiles sont disposées côte à côte ou de manière concentrique. Toutefois, la réalisation de tels capteurs pose d'autres problèmes.

Ainsi, le document US 2011/0300658 A1 décrit la réalisation d'un tel capteur comprenant deux masses mobiles superposées, à partir d'un substrat double SOI, c'est-à-dire comprenant, au-dessus d'une couche support et d'une couche diélectrique enterrée, deux couches superficielles de silicium superposées l'une au-dessus de l'autre et espacées l'une de l'autre par une autre couche diélectrique. L'inconvénient d'un tel procédé de réalisation est que les deux masses mobiles doivent être réalisées lors d'une même étape de gravure des deux couches superficielles de silicium. Les deux masses mobiles réalisées sont donc nécessairement identiques. De plus, la gravure multicouche devant être réalisée à travers l'empilement silicium/diélectrique/silicium en une seule étape technologique n'est pas évidente à mettre en œuvre. Ce procédé n'est donc pas adapté à la réalisation d'un capteur comprenant deux masses mobiles superposées de géométrie différente.

Dans les documents US 2005/0091843 A1 et US 2009/0283917 A1, il est proposé de former un capteur comprenant deux masses mobiles réalisées dans deux substrats distincts. Un scellement des deux substrats est ensuite effectué pour superposer les deux masses mobiles réalisées et obtenir le capteur. Avec ce procédé, les masses mobiles du capteur peuvent être similaires ou non. Toutefois, un inconvénient de ce procédé est que le scellement entre les deux substrats nécessite de réaliser un alignement des deux substrats l'un par rapport à l'autre. Cette étape d'alignement est très sensible et difficile à mettre en œuvre, et un désalignement entre les deux substrats peut engendrer notamment un désalignement des deux centres de gravité des masses mobiles superposées, ce qui peut compromettre l'équilibrage du capteur. Le document FR 3 013 441 A1 divulgue un micro-dispositif comportant deux éléments mobiles. Le premier élément mobile comprend une première portion d'une première couche de matériau et une deuxième portion d'une deuxième couche de matériau. Le deuxième élément mobile comprend une première portion de la deuxième couche de matériau et une deuxième portion de la première couche de matériau.

Dans le document US 2015/0375995 A1, il est décrit la réalisation d'un premier élément mobile d'un capteur dans un substrat, puis le scellement d'un capot recouvrant le premier élément mobile, puis un amincissement de la partie du substrat servant de poignée mécanique (au niveau de la face arrière du substrat), et enfin réalisation d'un deuxième élément mobile dans cette partie amincie du substrat depuis sa face arrière. Ce procédé permet la réalisation d'éléments mobiles similaires ou non. Toutefois, il est nécessaire de réaliser un scellement avec alignement du substrat et du capot. De plus, l'alignement du deuxième élément mobile par rapport au premier élément mobile pose des problèmes car les marques d'alignement disposées en face arrière du substrat et servant à l'alignement du capot disparaissent lors de l'amincissement de la partie du substrat servant de poignée mécanique. L'alignement du deuxième élément mobile doit donc être réalisé soit en utilisant une vision infrarouge des éléments, soit en réalisant l'alignement par rapport au capot reporté. Dans les deux cas, cela peut entraîner des désalignements importants entre les deux éléments mobiles.

### EXPOSÉ DE L'INVENTION

Un but de la présente invention est de proposer un micro-dispositif, par exemple de type capteur inertiel, comprenant au moins un élément mobile et ne présentant pas au moins une partie des inconvénients des micro-dispositifs de l'art antérieur, c'est-à-dire limitant ou supprimant l'effet de balourd dynamique, qui supprime les contraintes d'alignement rencontrées lors de la réalisation des micro-dispositifs de l'art antérieur, et qui puisse être réalisé de manière compacte avec un coût réduit.

Pour cela, la présente invention propose un micro-dispositif comprenant au moins :
- une première couche de matériau,
- une deuxième couche de matériau,
- une partie fixe,
- un premier élément mobile comprenant au moins une première portion de la première couche de matériau et au moins une deuxième portion de la deuxième couche de matériau,
- un deuxième élément mobile comprenant au moins une première portion de la deuxième couche de matériau et au moins une deuxième portion de la première couche de matériau,
- des premiers moyens de suspension formés dans la première couche de matériau et/ou dans la deuxième couche de matériau,
- des deuxièmes moyens de suspension formés dans la première couche de matériau et/ou dans la deuxième couche de matériau,et dans lequel :
- les premier et deuxième éléments mobiles sont aptes à se déplacer l'un par rapport à l'autre et par rapport à la partie fixe,
- les première et deuxième couches de matériau sont disposées l'une au-dessus de l'autre,
- la première portion de la première couche de matériau est solidaire de la deuxième portion de la deuxième couche de matériau,
- le premier élément mobile est suspendu à la partie fixe par les premiers moyens de suspension,
- le deuxième élément mobile est suspendu à la partie fixe par les deuxièmes moyens de suspension,
- la première portion de la deuxième couche de matériau est solidaire de la deuxième portion de la première couche de matériau.

Cette répartition des portions de matériau formant les éléments mobiles au sein des différentes couches de matériau évite d'engendrer un important balourd dynamique résultant du déplacement du centre de gravité global du micro-dispositif.

Les caractéristiques de ce micro-dispositif sont compatibles avec une réalisation n'impliquant pas la mise en œuvre d'un alignement d'éléments destinés à être scellés l'un à l'autre. Ce micro-dispositif peut dont être réalisé sans avoir à mettre en œuvre un tel alignement.

La réalisation d'un élément mobile au sein de deux couches superposées permet en outre de réduire l'encombrement de cet élément mobile.

Lorsque l'élément mobile comporte différentes portions issues de deux couches distinctes isolées électriquement l'une de l'autre, plusieurs potentiels électriques différents peuvent être appliqués sur cet élément mobile.

De manière générale, l'expression « couche de matériau » peut désigner une couche de matériau monolithique ou un ensemble de plusieurs couches superposées.

Les deuxièmes portions des première et deuxième couches de matériau peuvent correspondre à de simples portions de ces couches, par exemple de forme rectangulaire, ou bien être de géométrie plus complexe, par exemple formant un cadre, une pluralité de plots, une grille, etc.

Ce micro-dispositif comporte donc une partie fixe à laquelle sont suspendus au moins deux éléments mobiles superposés. La répartition des portions de matériau formant les éléments mobiles dans les deux couches de matériau peut correspondre à une disposition tête-bêche des éléments mobiles. Ces éléments mobiles peuvent donc être disposés de manière imbriquée l'un par rapport à l'autre au sein du micro-dispositif.

Les éléments mobiles peuvent être réalisés dans des couches de matériau superposées l'une au-dessus de l'autre. Cela réduit l'encombrement du micro-dispositif par rapport à ceux dans lesquels les éléments mobiles sont réalisés dans une même couche de matériau, soit l'un à côté de l'autre ou de manière concentrique, ce qui engendre un coût de réalisation moindre. Cet avantage se retrouve également lorsque le micro-dispositif ne comporte qu'un seul élément mobile.

En outre, un tel micro-dispositif ne présente aucune contrainte limitant la forme et les dimensions des éléments mobiles qui peuvent être similaires ou non pour chacun des éléments mobiles. Lorsque la forme et les dimensions des éléments mobiles sont similaires, cela facilite l'équilibrage du micro-dispositif.

Selon l'invention, les premier et deuxième éléments mobiles sont aptes à se déplacer sensiblement en opposition de phase l'un par rapport à l'autre, lorsque le micro-dispositif est soumis à une action extérieure (déplacement, accélération, rotation, choc, etc.). Dans ce cas, la répartition des portions de matériau formant chacun des éléments mobiles au sein des deux couches est très avantageuse car le balourd dynamique qui pourrait être engendré par un tel déplacement est réduit.

Les premier et deuxième éléments mobiles peuvent être aptes à se déplacer sensiblement en phase l'un par rapport à l'autre.

Les centres de gravité des premier et deuxième éléments mobiles sont alignés l'un au-dessus de l'autre selon un axe sensiblement perpendiculaire à des faces principales des première et deuxième couches de matériau. Cette configuration réduit encore plus les effets de balourd dynamique global, voire les supprime.

Les premier et deuxième éléments mobiles peuvent être symétriques par rapport à un centre de symétrie se trouvant entre les premières portions des première et deuxième couches de matériau et sur l'axe sensiblement perpendiculaire aux faces principales des première et deuxième couches de matériau.

Le micro-dispositif peut être tel que :
- au moins une première extrémité de la première portion de la première couche de matériau est reliée à la deuxième portion de la deuxième couche de matériau et au moins une deuxième extrémité de la première portion de la première couche de matériau forme une extrémité libre du premier élément mobile, et
- au moins une première extrémité de la première portion de la deuxième couche de matériau est reliée à la deuxième portion de la première couche de matériau et au moins une deuxième extrémité de la première portion de la deuxième couche de matériau forme une extrémité libre du deuxième élément mobile.

Dans ce cas, la deuxième extrémité de la première portion de la première couche de matériau peut être disposée entre la première extrémité de la première portion de la première couche de matériau et la deuxième portion de la première couche de matériau, et la deuxième extrémité de la première portion de la deuxième couche de matériau peut être disposée entre la première extrémité de la première portion de la deuxième couche de matériau et la deuxième portion de la deuxième couche de matériau.

Les premier et deuxième éléments mobiles peuvent être disposés de manière imbriquée et/ou concentrique l'un par rapport à l'autre.

La première portion de la première couche de matériau peut être reliée à la deuxième portion de la deuxième couche de matériau par l'intermédiaire d'au moins une première portion d'une couche intermédiaire disposée entre les première et deuxième couches de matériau, et/ou la première portion de la deuxième couche de matériau peut être reliée à la deuxième portion de la première couche de matériau par l'intermédiaire d'au moins une deuxième portion de la couche intermédiaire.

Le micro-dispositif peut comporter en outre des éléments de détection et/ou de mesure d'un déplacement du premier élément mobile et/ou du deuxième élément mobile par rapport à la partie fixe et/ou d'un déplacement du premier élément mobile par rapport au deuxième élément mobile, et/ou des éléments aptes à déplacer le premier élément mobile et/ou le deuxième élément mobile par rapport à la partie fixe et/ou déplacer le premier élément mobile par rapport au deuxième élément mobile.

Dans une configuration avantageuse, le premier élément mobile peut former un premier élément de détection, et le deuxième élément mobile peut former un deuxième élément de détection, les premier et deuxième éléments de détection pouvant être aptes à réaliser une mesure inertielle de grandeurs angulaires subies par le micro-dispositif.

Le premier élément mobile et/ou le deuxième élément mobile peuvent être aptes à se déplacer en translation et/ou en rotation par rapport à la partie fixe et/ou l'un par rapport à l'autre.

La partie fixe peut comporter des portions des première et deuxième couches de matériau disposées autour des premier et deuxième éléments mobiles et/ou entourées par les premier et deuxième éléments mobiles.

La partie fixe peut comporter une couche support telle que la première couche de matériau soit disposée entre la couche support et la deuxième couche de matériau.

Selon un mode de réalisation particulier, le micro-dispositif peut comporter en outre au moins un élément mobile intermédiaire suspendu à la partie fixe et apte à se déplacer par rapport à la partie fixe, et les premier et deuxième éléments mobiles peuvent être suspendus à l'élément mobile intermédiaire et être aptes à se déplacer par rapport à l'élément mobile intermédiaire et à la partie fixe.

Dans ce mode de réalisation particulier, l'élément mobile intermédiaire assure une absorption des vibrations extérieures au micro-dispositif. Ainsi, les éléments mobiles ne subissent pas ces vibrations extérieures.

De plus, le micro-dispositif selon ce mode de réalisation particulier peut être tel que :
- la partie fixe comporte un cadre fixe entourant au moins en partie l'élément mobiles intermédiaire, et l'élément mobile intermédiaire forme un cadre mobile suspendu au cadre fixe, et/ou
- le micro-dispositif comporte en outre une première cavité dont au moins une partie des parois est formée par la partie fixe et dans laquelle est encapsulé l'élément mobile intermédiaire, et une deuxième cavité disposée au sein de la première cavité, dont au moins une partie des parois est formée par l'élément mobile intermédiaire et dans laquelle sont encapsulés les premier et deuxième éléments mobiles.

De manière avantageuse, la deuxième cavité peut être isolée de la première cavité.

Ainsi, il est possible d'encapsuler les premier et deuxième éléments mobiles au sein d'une atmosphère particulière (en termes de nature de gaz et/ou de pression) différente de celle dans laquelle se trouve l'élément mobile intermédiaire, par exemple différente de l'air ambiant dans lequel se trouve le micro-dispositif. La deuxième cavité peut être fermée hermétiquement ou de manière étanche vis-à-vis de la première cavité.

L'invention porte également sur un procédé de réalisation d'un micro-dispositif, comportant au moins :
- gravure d'une première couche de matériau telle qu'au moins une première portion de la première couche de matériau forme une première partie d'au moins un premier élément mobile et qu'au moins une deuxième portion de la première couche de matériau forme une première partie d'au moins un deuxième élément mobile,
- réalisation d'une deuxième couche de matériau sur la première couche de matériau,
- gravure de la deuxième couche de matériau telle qu'au moins une deuxième portion de la deuxième couche de matériau forme une deuxième partie du premier élément mobile et soit solidaire de la première portion de la première couche de matériau et qu'au moins une première portion de la deuxième couche de matériau forme une deuxième partie du deuxième élément mobile et soit solidaire de la deuxième portion de la première couche de matériau, ces étapes étant mises en œuvre telles que :
- le premier élément mobile soit suspendu à une partie fixe par des premiers moyens de suspension formés dans la première couche de matériau et/ou dans la deuxième couche de matériau,
- le deuxième élément mobile soit suspendu à la partie fixe par des deuxièmes moyens de suspension formés dans la première couche de matériau et/ou dans la deuxième couche de matériau,
- les premier et deuxième éléments mobiles soient aptes à se déplacer l'un par rapport à l'autre et par rapport à la partie fixe,
- les premier et deuxième éléments mobiles sont aptes à se déplacer sensiblement en opposition de phase l'un par rapport à l'autre lorsque le micro-dispositif est soumis à une action extérieure,
- les centres de gravité des premier et deuxième éléments mobiles sont alignés l'un au-dessus de l'autre selon un axe sensiblement perpendiculaire à des faces principales des première et deuxième couches de matériau.

La réalisation de la deuxième couche de matériau sur la première couche de matériau peut comporter un report de la deuxième couche de matériau sur la première couche de matériau tel qu'une couche intermédiaire soit disposée entre les première et deuxième couches de matériau, le procédé pouvant comporter en outre, après la gravure de la deuxième couche de matériau, une gravure de la couche intermédiaire telle qu'au moins une première portion de la couche intermédiaire relie la première portion de la première couche de matériau à la deuxième portion de la deuxième couche de matériau et, lorsque le deuxième élément mobile est réalisé, qu'au moins une deuxième portion de la couche intermédiaire relie la première portion de la deuxième couche de matériau à la deuxième portion de la première couche de matériau.

Selon un premier mode de réalisation, une couche sacrificielle peut être disposée entre la première couche de matériau et une couche support, le procédé pouvant comporter en outre, après la gravure de la deuxième couche de matériau, la réalisation d'un accès à la couche sacrificielle à travers la couche support puis une gravure d'une partie de la couche sacrificielle via l'accès formé à travers la couche support, libérant au moins la première portion de la première couche de matériau (et également la deuxième portion de la première couche de matériau lorsque le deuxième élément mobile est réalisé) vis-à-vis de la couche support. Dans ce cas, la libération du premier élément mobile (et du deuxième élément mobile lorsque celui-ci est réalisé) peut se faire depuis deux faces opposées du micro-dispositif.

Selon un deuxième mode de réalisation, une couche sacrificielle peut être disposée entre la première couche de matériau et une couche support, le procédé pouvant comporter en outre, entre la gravure de la première couche de matériau et la réalisation de la deuxième couche de matériau, une gravure d'une première partie de la couche sacrificielle libérant partiellement au moins la première portion de la première couche de matériau (et la deuxième portion de la première couche de matériau lorsque le deuxième élément mobile est réalisé) vis-à-vis de la couche support, et après la gravure de la deuxième couche de matériau, une gravure d'une deuxième partie de la couche sacrificielle via des ouvertures formées à travers les première et deuxième couches de matériau lors des précédentes gravures des première et deuxième couches de matériau, achevant la libération de la première portion de la première couche de matériau (et de la deuxième portion de la première couche de matériau lorsque le deuxième élément mobile est réalisé) vis-à-vis de la couche support. Dans ce cas, la libération du premier élément mobile, et éventuellement du deuxième élément mobile, peut être réalisée sans avoir à former un accès à la couche sacrificielle depuis une face arrière de la couche support, et uniquement depuis une face avant du micro-dispositif.

Les étapes de gravure des première et deuxième couches de matériau peuvent former des trous de libération traversant les première et deuxième couches de matériau et qui sont alignés les uns au-dessus des autres. Ainsi, la libération de la première portion (et éventuellement de la deuxième portion) de la première couche de matériau peut être réalisée en utilisant des agents de gravure atteignant la couche sacrificielle via ces trous de libération.

L'étape de gravure de la deuxième couche de matériau peut former des trous de libération additionnels traversant la deuxième couche de matériau. Cette configuration permet notamment d'obtenir des mobilités différentes des éléments mobiles l'un par rapport à l'autre, lorsque plusieurs éléments mobiles sont réalisés.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement un micro-dispositif, objet de la présente invention, selon un mode de réalisation particulier,
- les figures 2A à 2M représentent les étapes d'un procédé de réalisation d'un micro-dispositif, objet de la présente invention, selon un premier mode de réalisation,
- les figures 3A à 3H représentent les étapes d'un procédé de réalisation d'un micro-dispositif, objet de la présente invention, selon un deuxième mode de réalisation,
- la figure 4 représente schématiquement un micro-dispositif, objet de la présente invention, selon un autre mode de réalisation particulier,
- la figure 5 représente une vue en coupe d'une partie d'un micro-dispositif, objet de la présente invention, avant la mise en œuvre de la libération finale des éléments mobiles du micro-dispositif, en présence de trous de libération supplémentaires formés à travers la deuxième couche de matériau,
- les figures 6A et 6B représente des exemples de réalisation de trous de libération dans un micro-dispositif, objet de la présente invention,
- la figure 7 représente une vue en coupe d'une partie d'un micro-dispositif, objet de la présente invention, après la mise en œuvre de la libération finale des éléments mobiles du micro-dispositif, en l'absence de trous de libération supplémentaires formés à travers la deuxième couche de matériau,
- la figure 8 représente schématiquement un micro-dispositif, objet de la présente invention, comportant un élément mobile intermédiaire,
- les figures 9A à 9K représentent les étapes d'un procédé de réalisation d'un micro-dispositif, objet de la présente invention, comportant un élément mobile intermédiaire,
- la figure 10 représente schématiquement un micro-dispositif, qui ne fait pas partie de l'invention.
- les figures 11A et 11B représentent schématiquement un micro-dispositif, objet de la présente invention, selon un autre mode de réalisation,
- la figure 12 représente schématiquement un micro-dispositif, objet de la présente invention, selon un autre mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

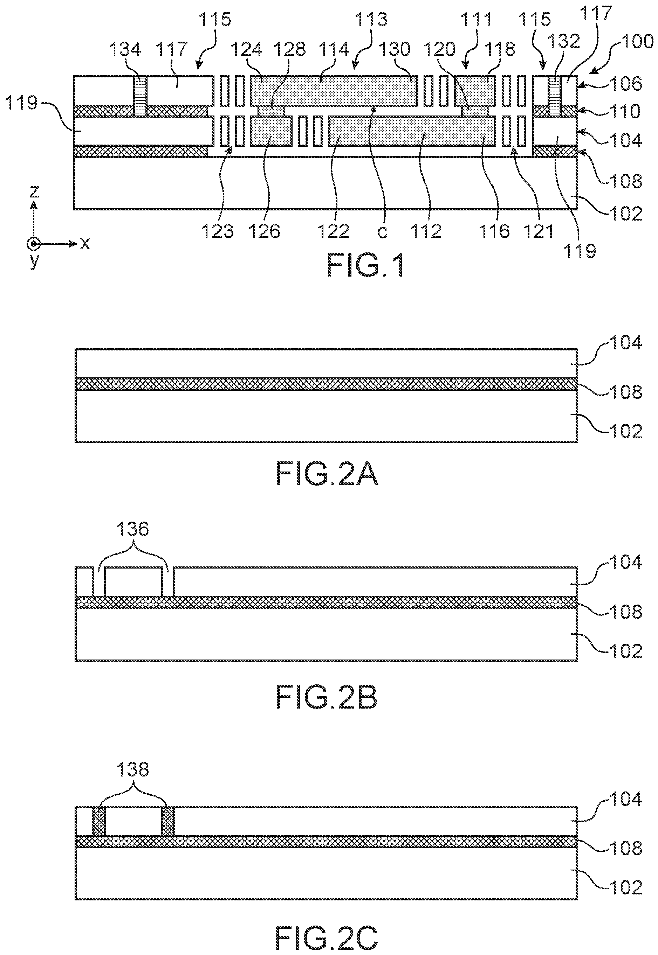

On se réfère tout d'abord à la figure 1 qui représente schématiquement un micro-dispositif 100 selon un mode de réalisation particulier.

Le micro-dispositif 100 est réalisé à partir d'un empilement comportant une couche support 102, une première couche de matériau 104 et une deuxième couche de matériau 106, la première couche 104 étant disposée entre la couche support 102 et la deuxième couche 106. Dans le mode de réalisation particulier décrit ici, le matériau des première et deuxième couches 104, 106 est un semi-conducteur, par exemple du silicium dopé ou non, du germanium dopé ou non, du SiGe, etc.

Une couche 108, appelée couche sacrificielle, est disposée entre la couche support 102 et la première couche 104. De plus, une couche 110, appelée couche intermédiaire, est disposée entre la première couche 104 et la deuxième couche 106. Dans le mode de réalisation particulier décrit ici, les couches 108, 110 comportent chacune un matériau diélectrique, par exemple du SiO₂. De manière générale, les matériaux des couches 108, 110 sont tels qu'ils puissent être gravés sélectivement vis-à-vis des matériaux des première et deuxième couches 104, 106.

Le micro-dispositif 100 représenté sur la figure 1 correspond à un capteur inertiel comportant un premier élément mobile 111 formé par une première portion 112 de la première couche 104 et une deuxième portion 118 de la deuxième couche 106, et un deuxième élément mobile 113 formé par une première portion 114 de la deuxième couche 106 et une deuxième portion 126 de la première couche 104.

La première portion 112 de la première couche 104 comporte une première extrémité 116 reliée, ou solidarisée, à la deuxième portion 118 de la deuxième couche 106 par l'intermédiaire d'une première portion 120 de la couche intermédiaire 110. La première portion 120 de la couche intermédiaire 110 fait partie du premier élément mobile 111. La première portion 112 comporte une deuxième extrémité 122 formant une extrémité libre du premier élément mobile 111, c'est-à-dire une extrémité qui n'est pas en contact avec une portion de la couche intermédiaire 110.

La première portion 114 de la deuxième couche 106 comporte une première extrémité 124 reliée à la deuxième portion 126 de la première couche 104 par l'intermédiaire d'une deuxième portion 128 de la couche intermédiaire 110 faisant partie du deuxième élément mobile 113. La première portion 114 de la deuxième couche 106 comporte une deuxième extrémité 130 formant une extrémité libre du deuxième élément mobile 112.

Dans ce micro-dispositif 100, les premier et deuxième éléments mobiles 111, 113 forment des masses mobiles, ou masses sismiques, aptes à se déplacer par rapport à une partie fixe 115 du micro-dispositif 100. La partie fixe 115 comporte des portions 117, 119 des première et deuxième couches 104, 106 auxquelles sont suspendus les éléments mobiles 111, 113 par l'intermédiaire respectivement de premiers et deuxièmes moyens de suspension 121, 123. Dans le mode de réalisation particulier représenté sur la figure 1, ces premiers et deuxièmes moyens de suspension 121, 123 correspondent à des portions des première et deuxième couches de matériau 104, 106 formant des micro-poutres suspendant les portions 112, 114, 118 et 126 des éléments mobiles 111, 113 aux portions 117, 119 des première et deuxième couches de matériau 104, 106. La partie fixe 115 inclut également la couche support 102.

En variante, il est possible que les moyens de suspension 121, 123 ne soient formés que par des portions d'une seule des deux couches de matériau 104, 106. Par exemple, l'un ou chacun des éléments mobiles 111, 113 peut être suspendu à la partie fixe 115 par des micro-poutres reliées uniquement à la première portion 112, 114, ou à la deuxième portion 118, 126.

Chacun des éléments mobiles 111, 113 est formé par une portion d'une des couches 104, 106 reliée à une portion de l'autre des couches 104, 106, les deux éléments mobiles 111, 113 étant disposés de manière imbriquée l'un par rapport à l'autre.

Dans le mode de réalisation particulier décrit en lien avec la figure 1, ces deux éléments de détection correspondant aux deux éléments mobiles 111, 113 sont identiques l'un par rapport à l'autre et disposés tête-bêche l'un par rapport à l'autre, c'est-à-dire sont symétriques par rapport à un centre de symétrie C localisé entre les premières portions 112, 114 des première et deuxième couches 104, 106. Dans le mode de réalisation décrit en lien avec la figure 1, la deuxième extrémité 122 de la première portion 112 de la première couche 104 est disposée entre la première extrémité 116 de la première portion 112 de la première couche 104 et la deuxième portion 126 de la première couche 104, et la deuxième extrémité 130 de la première portion 114 de la deuxième couche 106 est disposée entre la première extrémité 124 de la première portion 114 de la deuxième couche 106 et la deuxième portion 118 de la deuxième couche 106.

Dans ce mode de réalisation particulier, les centres de gravité des premier et deuxième éléments mobiles 111, 113 sont alignés l'un au-dessus de l'autre selon un axe sensiblement perpendiculaire à des faces principales des première et deuxième couches de matériau 104, 106 (faces parallèles au plan (X,Y)), c'est-à-dire ici alignés selon un axe parallèle à l'axe Z et passant par le centre de symétrie C.

Ainsi, lorsque le micro-dispositif 100 est soumis à des forces extérieures, le déplacement en opposition de phase des premier et deuxième éléments mobiles 111, 113 n'engendre pas ou peu de balourd dynamique.

En variante, il est possible que ces éléments mobiles 111, 113 soient différents l'un de l'autre, c'est-à-dire qu'ils n'aient pas la même forme et/ou pas les mêmes dimensions.

Enfin, le micro-dispositif 100 comporte ici des vias électriquement conducteurs 132, 134 reliant électriquement les première et deuxième couches 104, 106 entre elles.

Des portions de matériau d'au moins une des couches 104, 106 peuvent également relier le premier élément mobile 111 au deuxième élément mobile 113. De telles portions peuvent ainsi assurer un certain maintien mécanique des premières portions 112, 114. Toutefois, ces portions de matériau, qui correspondent par exemple à des micro-poutres, sont telles que les éléments mobiles 111, 113 sont mobiles l'une par rapport à l'autre.

Les figures 2A à 2M représentent les étapes d'un procédé de réalisation d'un micro-dispositif 100 selon un premier mode de réalisation.

Le micro-dispositif 100 est par exemple réalisé à partir d'un premier substrat de type semi-conducteur sur isolant, par exemple SOI (silicium sur isolant), SiGeOl, GeOl, etc. Ce substrat, visible sur la figure 2A, comporte la couche support 102, une couche diélectrique enterrée, ou BOX (« Buried Oxide »), formant la couche sacrificielle 108 et comprenant par exemple de l'oxyde de semi-conducteur tel que du SiO₂, et une couche superficielle de semi-conducteur comprenant par exemple du silicium et formant la première couche de matériau 104. L'épaisseur de chacune des couches 104 et 108 est par exemple comprise entre environ 100 nm et 400 µm, voire même supérieure à 400 µm. Par exemple, l'épaisseur de la couche 104 est typiquement égale à environ 60 µm, et celle de la couche 108 égale à environ 2 µm. De manière générale, la première couche 104 correspond à une couche de matériau adapté à la réalisation d'un des éléments mobiles du micro-dispositif 100, et le matériau de la couche sacrificielle 108 est apte à être gravé sélectivement vis-à-vis de celui de la première couche 104.

En variante, le micro-dispositif 100 peut être réalisé à partir d'un substrat massif, ou bulk, comprenant par exemple un semi-conducteur tel que du silicium et formant la couche support 102, sur lequel sont déposées successivement la couche sacrificielle 108, par exemple diélectrique telle qu'une couche d'oxyde de semi-conducteur ou bien du verre, et la première couche de matériau 104 dans laquelle l'un des éléments mobiles du micro-dispositif 100 est destiné à être réalisé, correspondant par exemple à une couche de semi-conducteur tel que du silicium dopé ou non, du germanium dopé ou non, etc. La couche sacrificielle 108 et la première couche de matériau 104 peuvent être formées en mettant en œuvre différentes techniques telles que des dépôts de type LPCVD (dépôt chimique par phase vapeur basse pression), PECVD (dépôt chimique par phase vapeur assisté par plasma), ALD (dépôt de couche atomique), PVD (dépôt physique par phase vapeur), ou encore par épitaxie, etc.

Lorsque différentes régions de la première couche de matériau 104 sont destinées à être soumises à des potentiels électriques différents, la première couche 104 peut être structurée de façon à définir une ou plusieurs tranchées d'isolation électrique 136 entre ces différentes zones de la première couche 104 (figure 2B). Par exemple, une gravure de type DRIE (gravure ionique réactive profonde) peut être mise en œuvre pour former ces tranchées 136, une telle gravure permettant une gravure très sélective et profonde du semi-conducteur (ici du silicium) de la première couche 104, la couche sacrificielle 108 servant de couche d'arrêt à cette gravure.

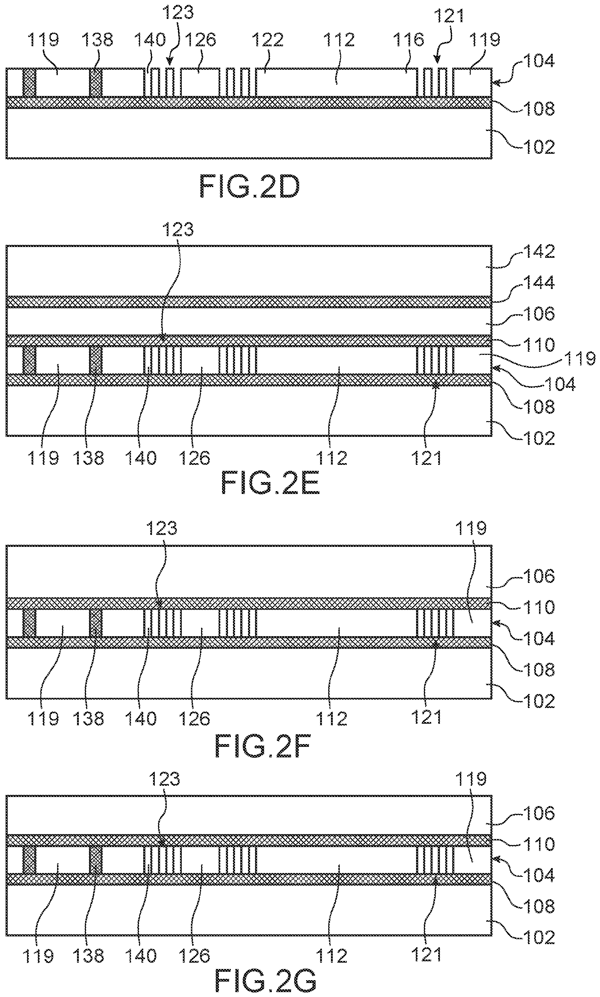

Cette ou ces tranchées 136 peuvent ensuite être bouchées ou non par au moins un matériau diélectrique 138 (figure 2C). Ce matériau diélectrique 138 peut être par exemple un oxyde thermique, un nitrure, du polysilicium non dopé, ou une combinaison de différents matériaux diélectriques. Le remplissage de ces tranchées 136 par le matériau diélectrique 138 permettra d'obtenir une meilleure tenue mécanique de la structure mobile ayant des zones de potentiels électriques différents qui sera réalisée dans la première couche 104. Les documents « Fabrication challenges and test structures for high-aspect-ratio SOI MEMS devices with refilled electrical isolation trenches » de J. Xie, Microsyst. Technol. (2015) 21 :1719-1727, et « Fabrication of keyhole-free ultra-deep high-aspect-ratio isolation trench and its applications » de Y. Zhu et al., J. Micomech. Microeng. 15 (2005), 636-642, décrivent la réalisation de telles tranchées remplies de matériau diélectrique. Si les tranchées 136 ne sont pas ensuite bouchées par le matériau diélectrique 138, elles peuvent être réalisées ultérieurement, par exemple en même temps que la structuration de la première couche 104 formant les portions 112 et 126 des éléments mobiles 111, 113 du micro-dispositif 100 (voir étape décrite ci-dessous en lien avec la figure 2D).

En variante, il est possible de ne pas réaliser les tranchées 136 si le micro-dispositif 100 ne nécessite pas d'avoir, dans la première couche 104, différentes zones isolées électriquement les unes des autres.

La première couche de matériau 104 est ensuite structurée, ici par gravure (par exemple DRIE) de façon à définir la première portion 112 destinée à faire partie du premier élément mobile 111 et la deuxième portion 126 destinée à faire partie du deuxième élément mobile 113 (figure 2D). Une partie des moyens de suspension 121, 123 (ceux destinés à maintenir dans un état suspendu les portions 112 et 126 vis-à-vis des portions 119) sont également réalisés dans la première couche 104, ainsi que les portions 119 de la partie fixe 115 du micro-dispositif 100. Des éléments de détection et/ou de mesure du déplacement d'un ou des éléments mobiles 111, 113, par exemple des peignes électrostatiques, peuvent également être réalisés dans la première couche 104. Suivant la nature du micro-dispositif 100, il est également possible que cette structuration de la première couche 104 forme des éléments aptes à déplacer, c'est-à-dire des moyens d'actionnement, les ou l'un des éléments mobiles 111, 113. Enfin, des trous de libération 140 destinés à la libération ultérieure des portions 112, 126 vis-à-vis de la couche support 102 sont également réalisés à travers la première couche 104. Ces trous de libération 140 serviront lors de la gravure de la couche sacrificielle 108 qui sera mise en œuvre pour libérer les portions 112, 126 vis-à-vis de la couche support 102.

La seconde couche de matériau 106 est ensuite réalisée sur la première couche de matériau 104. Dans le premier mode de réalisation décrit ici, la seconde couche 106 correspond à la couche superficielle d'un second substrat de type semi-conducteur sur isolant, par exemple SOI, SiGeOl, GeOl, etc. Ce second substrat comporte une couche massive 142 et une couche diélectrique enterrée 144 disposée entre la couche massive 142 et la seconde couche de matériau 106.

Ce second substrat peut être reporté sur la première couche de matériau 104 selon différentes techniques : collage direct entre la première couche 104 et la deuxième couche 106 (collage direct silicium / silicium par exemple, ou plus généralement semi-conducteur / semi-conducteur), ou bien un collage direct entre l'une des première et deuxième couches 104, 106 et une couche diélectrique formée au préalable sur l'autre des première et deuxième couches 104, 106 (collage direct semi-conducteur / diélectrique, par exemple silicium / SiO₂), ou bien un collage direct entre deux couches diélectriques formées au préalable sur chacune des première et deuxième couches 104, 106 (collage direct diélectrique / diélectrique, par exemple SiO₂ / SiO₂). En variante, cette solidarisation entre les première et deuxième couches 104, 106 peut être réalisée par scellement métallique (par exemple de type Au/Si, Au/Au, Au/Sn, Al/Ge, etc.) en formant au préalable sur au moins l'une des deux couches 104, 106 une telle couche ou cordon métallique. Une solidarisation des deux couches 104, 106 peut également être réalisée par l'intermédiaire d'un cordon de scellement non-métallique, par exemple polymère.

Sur l'exemple de la figure 2E, un collage direct diélectrique/diélectrique ou semi-conducteur/diélectrique est mis en œuvre pour solidariser les deux couches 104, 106. Une couche intermédiaire 110, comprenant un matériau diélectrique tel que du SiO₂, est présente entre les couches 104, 106.

En variante, la deuxième couche de matériau 106 peut ne pas être la couche superficielle d'un substrat de type semi-conducteur sur isolant, mais être une simple couche de matériau, par exemple de semi-conducteur, déposée sur la première couche 104, avec éventuellement la présence de la couche intermédiaire 110 entre les couches 104, 106. La figure 2F représente une telle variante, dans laquelle la deuxième couche 106 et la couche intermédiaire 110 sont déposées par exemple par LPCVD, PECVD, ALD, PVD, épitaxie, etc.

Comme représenté sur la figure 2G, les couches 142 et 144 sont retirées. La deuxième couche 106 est éventuellement amincie à l'épaisseur souhaitée. Lorsque la deuxième couche 106 est réalisée directement par dépôt, cet amincissement est généralement mis en œuvre en raison de l'épaisseur de matériau déposé qui ne correspond généralement pas à l'épaisseur souhaitée du deuxième élément mobile 114. L'épaisseur de la deuxième couche 106 peut être comprise entre environ 100 nm et 400 µm, voire supérieure à environ 400 µm, et par exemple égale à environ 60 µm. L'épaisseur de la deuxième couche 106 est égale ou non à celle de la première couche 104.

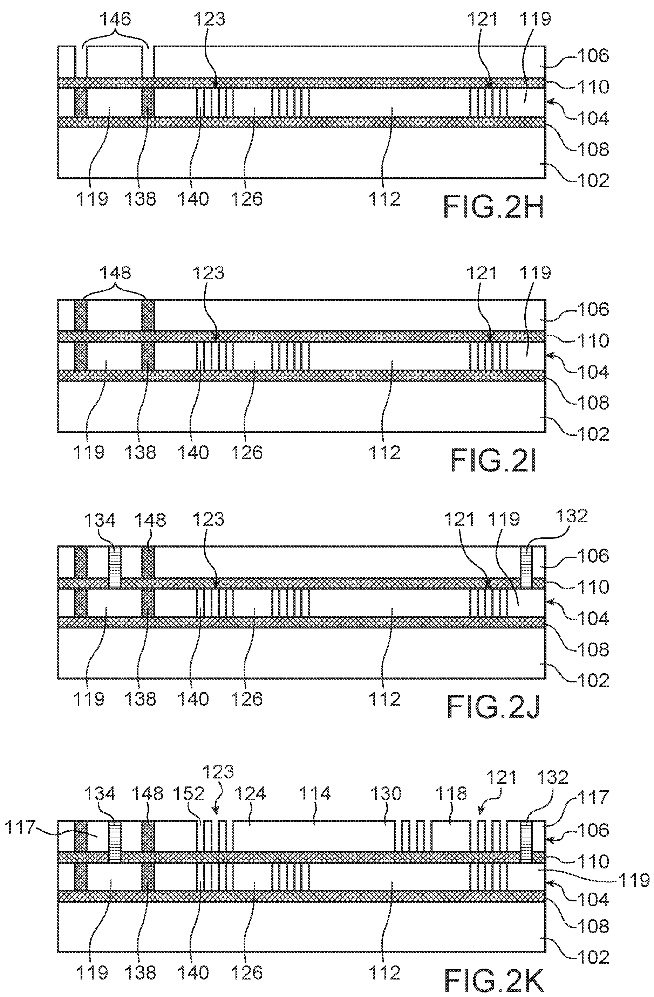

Comme précédemment décrit pour la première couche 104, lorsque différentes régions de la deuxième couche de matériau 106 sont destinées à être soumises à des potentiels électriques différents, la deuxième couche 106 peut être structurée de façon à définir une ou plusieurs tranchées d'isolation électrique 146 entre ces différentes zones de la deuxième couche 106 (figure 2H). Par exemple, une gravure de type DRIE peut être mise en œuvre pour former ces tranchées 146, la couche intermédiaire 110 servant ici de couche d'arrêt.

Cette ou ces tranchées 146 peuvent ensuite être bouchées ou non par au moins un matériau diélectrique 148 (figure 2I). Ce matériau diélectrique 148 peut être par exemple l'un des matériaux précédemment mentionnés pour le matériau diélectrique 138. Si les tranchées 146 ne sont pas bouchées par le matériau diélectrique 148, elles peuvent être réalisées ultérieurement, par exemple en même temps que la structuration de la deuxième couche 106 formant les autres portions 114, 118 des éléments mobiles 111, 113 du micro-dispositif 100 (voir étape décrite ci-dessous en lien avec la figure 2K).

Les deux couches 104 et 106 peuvent être reliées électriquement en réalisant un ou plusieurs vias d'interconnexion 132, 134 entre ces deux couches (figure 2J). Ce ou ces vias 132, 134 sont réalisés par la gravure successive des couches 106 et 110 avec un arrêt sur la première couche 104. Ce ou ces vias sont ensuite remplis par un matériau électriquement conducteur (par exemple un matériau métallique tel que de l'Al, du W, du Cu, de l'Au, ou un semi-conducteur dopé tel que du Si ou du Ge).

La deuxième couche 106 est ensuite structurée, par exemple par gravure, de façon à définir les portions 114, 118 des éléments mobiles 111, 113, ainsi que les portions 117 de la partie fixe 115 et les moyens de suspension 121, 123 des portions 114, 118 vis-à-vis des portions 117 (figure 2K). Des éléments de détection et/ou de mesure du déplacement d'un ou des éléments mobiles 111, 113, par exemple des peignes électrostatiques, peuvent également être formés dans la deuxième couche 106. Suivant la nature du micro-dispositif 100, il est également possible que cette structuration de la deuxième couche 106 forme des éléments aptes à déplacer les ou l'un des éléments mobiles 111, 113, c'est-à-dire des moyens d'actionnement. Enfin, des trous de libération 152 destinés à la libération ultérieure des portions 114, 118 vis-à-vis de la couche intermédiaire 110 sont également réalisés à travers la deuxième couche 106. Ces trous de libération 152 serviront lors de la gravure de la couche intermédiaire 110 qui sera mise en œuvre pour libérer ces portions 114, 118.

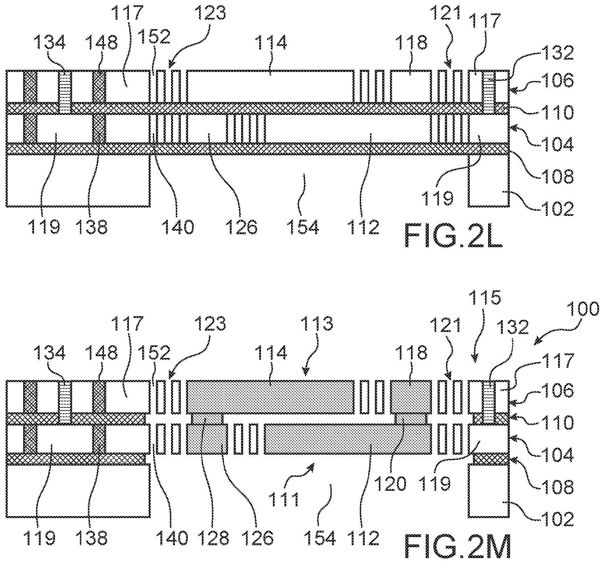

Comme représenté sur la figure 2L, une gravure d'une portion de la couche support 102, depuis sa face arrière, est ensuite mise en œuvre, formant un accès 154 à la couche sacrificielle 108. Cet accès 154 est localisé en regard des portions 112, 126.

Les éléments mobiles 111, 113 sont ensuite libérés via un retrait sélectif des matériaux des couches 108, 110 (diélectriques) par rapport aux autres matériaux des couches 102, 104, 106 (semi-conducteurs), comme représenté sur la figure 2M. Des portions 120, 128 de la couche intermédiaire 110 sont conservées, ces portions assurant le lien entre les premières portions 112, 114 et les deuxièmes portions 118, 126.

Toutes les gravures des première et deuxième couches 104, 106 mises en œuvre (précédemment décrites en lien avec les figures 2B, 2D, 2H, 2J et 2K) au cours de ce procédé sont avantageusement mises en œuvre en utilisant des marques d'alignement, ou référentiels d'alignement, présentes sur la face arrière de la couche support 102 (celle se trouvant du côté opposé à celui où se trouve la couche sacrificielle 108), de préférence sur une partie de cette face arrière qui ne sera pas gravée pour former l'accès 154. Du fait que ces marques d'alignement sont conservées jusqu'à la libération des éléments mobiles 111, 113, elles peuvent être utilisées pour réaliser ces éléments mobiles 111, 113 de manière alignée l'un par rapport à l'autre. L'alignement par rapport à de telles marques peut se faire, par exemple, avec des systèmes optiques ou interférentiels communément utilisés sur des équipements de photolithographie.

En variante, il est possible que l'accès 154 ne soit pas formé en gravant toute la portion de la couche support 102 se trouvant en regard des portions 112 et 126, mais en formant des trous de libération à travers cette portion de la couche support 102

Le micro-dispositif 100 précédemment décrit comporte deux éléments de détection, comportant chacun au moins un élément mobile formé de deux portions des couches 104, 106, réalisés de manière imbriquée l'un au-dessus de l'autre. En variante, le micro-dispositif 100 peut comporter un plus grand nombre d'éléments de détection, ou éléments mobiles, réalisés de manière imbriquée les uns au-dessus des autres. Pour cela, les étapes précédemment décrites en lien avec les figures 2E à 2K sont dans ce cas répétées une ou plusieurs fois avant de réaliser la libération des éléments mobiles de ces éléments superposés.

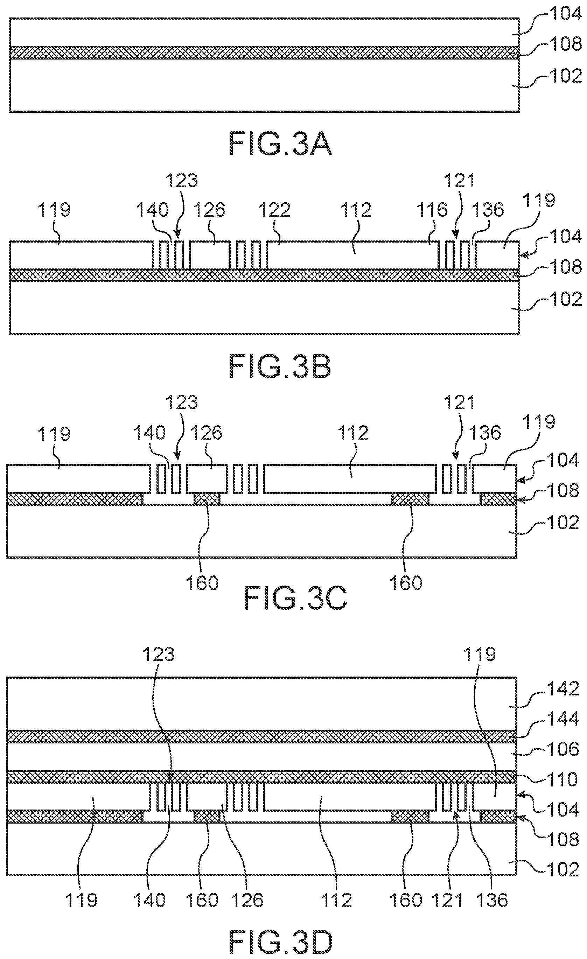

Les figures 3A à 3H représentent les étapes d'un procédé de réalisation d'un micro-dispositif 100 selon un deuxième mode de réalisation.

Comme dans le premier mode de réalisation, le procédé est mis en œuvre à partir d'un empilement de couches comportant la couche support 102, la couche sacrificielle 108 et la première couche de matériau 104 (figure 3A).

Au cours d'une même étape de gravure, les tranchées d'isolation électrique 136, les trous de libération 140 ainsi que les portions 112 et 126 des éléments mobiles 111, 113 et les parties des moyens de suspension 121, 123 reliés aux portions 112, 126 sont ensuite réalisés dans la première couche 104 (figure 3B). Dans ce deuxième mode de réalisation, les tranchées 136 ne sont pas bouchées ensuite par le matériau diélectrique 138 (mais elles pourraient l'être, comme dans le premier mode de réalisation), ce qui permet d'éviter les risques de dilatation thermique pouvant apparaitre à cause de la différence de coefficients d'expansion thermique entre le matériau diélectrique 138 et le matériau de la première couche 104. D'autres éléments de détection et/ou d'actionnement des éléments mobiles 111, 113 peuvent également être formés dans la première couche 104.

Une gravure partielle de la couche sacrificielle 108 est ensuite mise en œuvre afin de libérer partiellement les portions 112 et 126. Des portions 160 de la couche sacrificielle 108 sont conservées sous les portions 112, 126 (et plus généralement des différents éléments réalisés dans la première couche 104) afin de conserver une certaine tenue mécanique de ces éléments au cours de la suite du procédé.

La seconde couche de matériau 106 est ensuite réalisée sur la première couche de matériau 104. Comme dans le premier mode de réalisation, la seconde couche 106 correspond ici à la couche superficielle d'un second substrat de type semi-conducteur sur isolant comportant la couche massive 142 et la couche diélectrique enterrée 144. En outre, la couche intermédiaire 110 est également présente entre les couches 104, 106 (figure 3D). Les différentes techniques de scellement précédemment décrites pour le premier mode de réalisation peuvent s'appliquer à ce deuxième mode de réalisation. En variante, la deuxième couche de matériau 106 peut ne pas être la couche superficielle d'un substrat de type semi-conducteur, mais être une simple couche de matériau, par exemple de semi-conducteur, déposée sur la première couche 104, avec éventuellement la présence de la couche intermédiaire 110 entre les couches 104, 106.

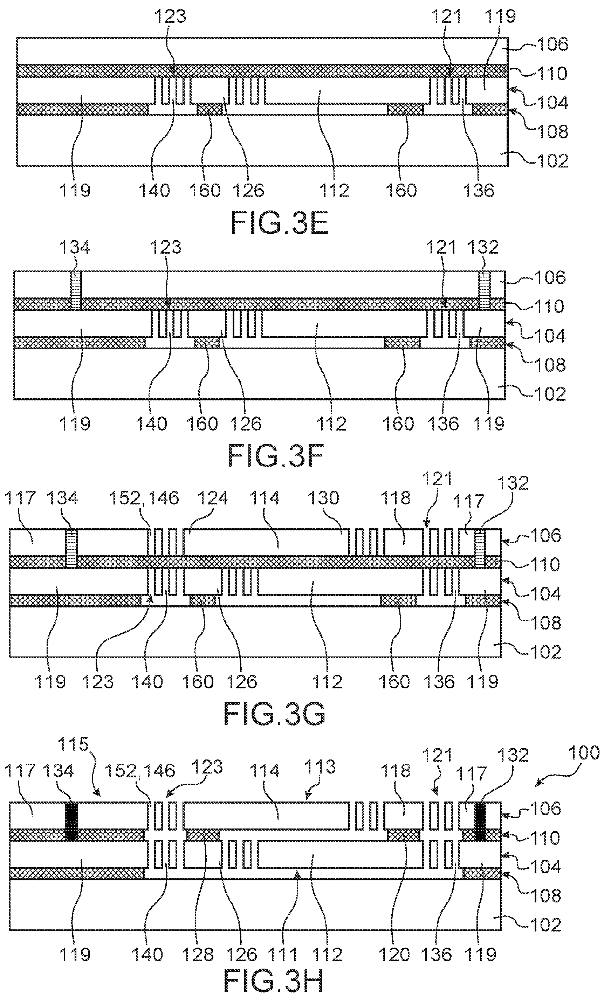

Comme représenté sur la figure 3E, les couches 142 et 144 sont retirées. La deuxième couche 106 est ici également amincie à l'épaisseur souhaitée.

Comme dans le premier mode de réalisation, les deux couches 104 et 106 peuvent être reliées électriquement en réalisant un ou plusieurs vias d'interconnexion 132, 134 entre ces deux couches (figure 3F). La deuxième couche 106 est ensuite structurée, par exemple par gravure, de façon à définir les portions 114, 118, les trous de libération 152, les éléments de maintien 121, 123, de détection et/ou d'actionnement précédemment décrits pour le premier mode de réalisation (figure 3G). Cette gravure sert ici également à former les tranchées d'isolation 146 qui sont ensuite remplies ou non du matériau diélectrique 148 (non replies dans ce deuxième mode de réalisation).

Les éléments mobiles 111, 113 sont ensuite libérés via un retrait sélectif des matériaux des couches 108, 110 par rapport aux autres matériaux des couches 102, 104, 106, comme représenté sur la figure 3H. En raison de la libération partielle des éléments de la première couche 104 (portions 112 et 126) précédemment réalisée, il n'est pas nécessaire de réaliser, préalablement à cette étape de libération, une gravure de la couche support 102 pour former un accès à la couche sacrificielle 108. Les agents de gravure utilisés réalisent donc la gravure des portions 160 à travers les trous de libération 152 et 140.

Comme dans le premier mode de réalisation, des portions 120, 128 de la couche intermédiaire 110 sont conservées, ces portions assurant le lien mécanique entre les premières portions 112, 114 et les deuxièmes portions 118, 126.

De plus, comme dans le premier mode de réalisation, toutes les gravures des première et deuxième couches 104, 106 mises en œuvre au cours de ce procédé sont avantageusement mises en œuvre en utilisant des marques d'alignement, ou référentiel d'alignement, présentes sur la face arrière de la couche support 102. Du fait qu'aucun accès à la couche sacrificielle 108 n'est réalisé à travers la couche support 102, toute la surface de la face arrière de couche support 102 est disponible pour ces marques d'alignement.

Le micro-dispositif 100 précédemment décrit comporte deux éléments de détection, comportant chacun au moins un élément mobile chacun formé de portions des deux couches 104, 106, réalisés de manière imbriquée l'une au-dessus de l'autre. En variante, le micro-dispositif 100 peut comporter un plus grand nombre d'éléments de détection réalisés de manière imbriquée les uns au-dessus des autres. Pour cela, les étapes précédemment décrites en lien avec les figures 3D à 3G sont dans ce cas répétées une ou plusieurs fois avant de réaliser la libération des éléments mobiles de ces éléments superposés.

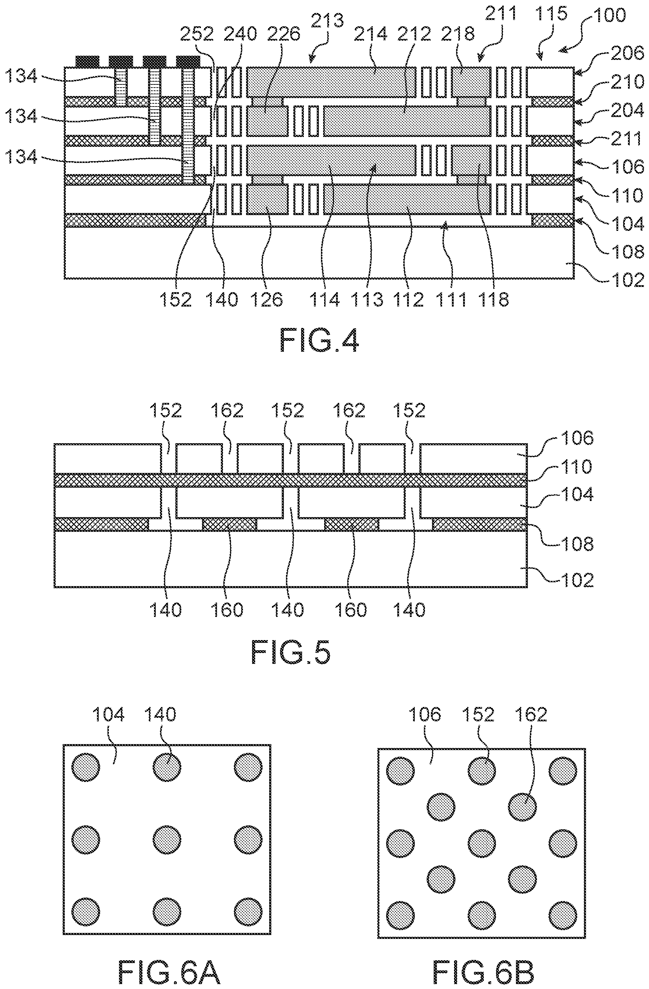

Un exemple de réalisation d'un tel micro-dispositif 100 comportant un plus grand nombre d'éléments de détection réalisés de manière imbriquée les uns au-dessus des autres est représenté sur la figure 4. Sur cette figure, deux couches de matériau supplémentaires 204, 206 sont disposées au-dessus de la deuxième couche 106, dans lesquelles des éléments de détection analogues à ceux réalisés dans les couches 104, 106 sont également réalisés, notamment des éléments mobiles 211, 213 chacun suspendu à la partie fixe 115 qui est commune aux éléments mobiles 111, 113, 211 et 213. Les couches 204, 206 sont disposées chacune sur une des couches intermédiaires 210 et 211. En outre, sur cet exemple de réalisation, les vias 134 forment des contacts électriques pour chacune des couches 104, 106, 204, 206. Enfin, des trous de libération 240, 252 formés dans les couches 204, 206 sont alignés avec ceux formés dans les couches 104, 106.

Il est possible que chaque élément mobile comporte des portions de deux, ou de plus de deux, couches de matériau consécutives.

Dans le deuxième mode de réalisation précédemment décrit, la libération des deux éléments de détection réalisés dans les couches 104, 106 est obtenue en introduisant des agents de gravure depuis la face supérieure de la deuxième couche 106. La distance entre cette face supérieure et les portions 160 de la couche sacrificielle 108 à graver lors de la libération des structures de détection est différente de celle entre cette face supérieure et la couche intermédiaire 110. De plus, du fait de la libération partielle de la structure formée dans la première couche 104 mise en œuvre préalablement à la réalisation de la deuxième couche 106, les portions de matériau à graver dans les couches 108 et 110 ne sont pas les mêmes. Pour réaliser la gravure des portions 160 de la couche sacrificielle 108 conservées à l'issue de l'étape de libération partielle, les trous de libération 140 formés à travers la première couche 104 sont alignés avec au moins une partie des trous de libération 152 formés à travers la deuxième couche 106. De plus, comme représenté sur la figure 5, il est possible de réaliser des trous de libération additionnels 162 à travers la deuxième couche 106 du fait que lors de l'étape de libération finale, la couche intermédiaire 110 n'a pas été encore gravée, contrairement à la couche sacrificielle 108. Une vue du dessus de la première couche 104 comportant les trous de libération 140 est visible sur la figure 6A, et une vue de dessus de la deuxième couche 106 comportant les trous de libération 152 alignés avec les trous 140, ainsi que les trous de libération supplémentaire 162, est visible sur la figure 6B.

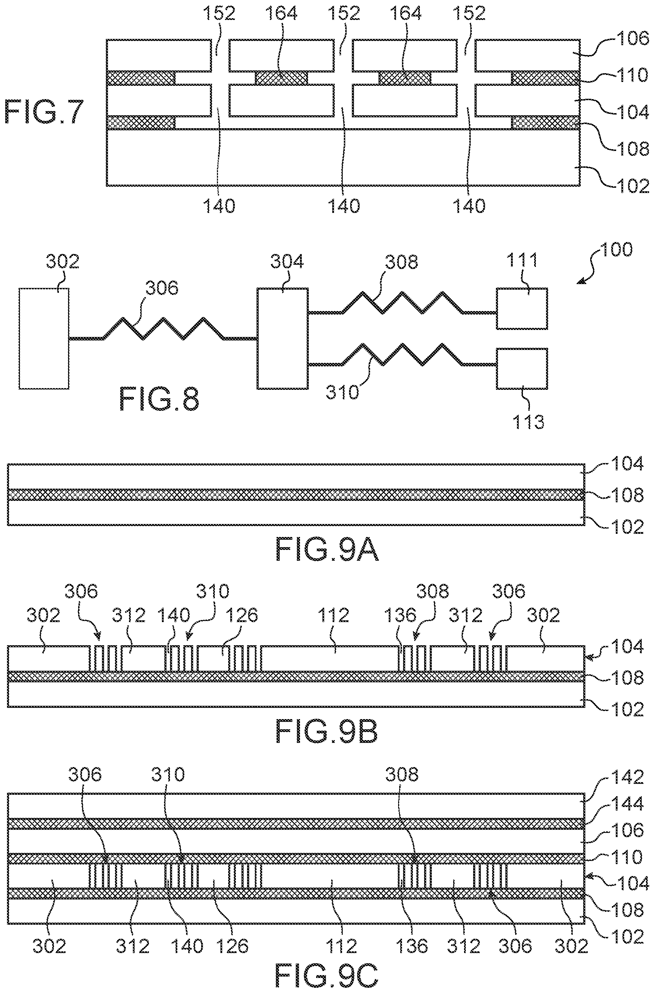

En variante, il est également possible de ne pas réaliser les trous de libération supplémentaires 162. Dans ce cas, à l'issue de l'étape de libération, des portions 164 de la couche intermédiaire 110 peuvent être encore présentes sous certaines parties de la deuxième couche 106 (voir figure 7). Cette configuration peut être avantageuse lorsqu'une tenue mécanique différente est recherchée pour les éléments formés dans la deuxième couche 106 par rapport à ceux formés dans la première couche 104.

Pour certaines applications, il peut être intéressant d'isoler les éléments mobiles du micro-dispositif 100 résonant vis-à-vis des vibrations extérieures à ce micro-dispositif 100. Pour cela, le micro-dispositif 100 peut être réalisé en réalisant les structures mobiles non pas telles que les éléments mobiles 111, 113 soient suspendus directement à la partie fixe 115 du micro-dispositif 100 qui comprend par exemple la couche support 102, mais solidaires d'un élément mobile intermédiaire, par exemple sous la forme d'un cadre mobile, formant un étage de suspension intermédiaire entre les éléments mobiles 111, 113 et cette partie fixe 115 du micro-dispositif 100. Les éléments mobiles 111, 113 sont dans ce cas suspendus dans et à ce cadre mobile, lui-même relié à la partie fixe par des moyens de suspension. Dans une telle configuration, le cadre mobile peut, par exemple, être fermé hermétiquement afin d'assurer un vide, ou plus généralement une atmosphère (nature de gaz, pression, etc.) adaptée au fonctionnement des structures mobiles.

Comme représenté schématiquement sur la figure 8, le micro-dispositif 100 comporte une partie fixe 302 dont la couche support 102 fait par exemple partie. Il comporte également un élément mobile intermédiaire 304 correspondant, dans cet exemple de réalisation, à un cadre mobile. L'élément mobile intermédiaire 304 est disposé par exemple à l'intérieur d'un espace entouré par un cadre formé par la partie fixe 302. De plus, l'élément mobile intermédiaire 304 est suspendu à la partie fixe 302 par des premiers moyens de maintien 306 correspondant par exemple à des premiers bras de maintien en suspension pouvant correspondre à des micro-poutres.

Ces premiers moyens de maintien 306 sont tels que l'élément mobile intermédiaire 304 peut se déplacer selon un ou plusieurs degrés de liberté par rapport à la partie fixe 302 du micro-dispositif 100, par exemple en translation parallèlement à l'un des axes X, Y ou Z, et/ou une rotation selon au moins l'un des axes X, Y ou Z.

Chacun des éléments mobiles 111, 113 est relié à l'élément mobile intermédiaire 304 par des deuxièmes moyens de maintien 308, 310 correspondant par exemple à des deuxièmes bras de maintien en suspension pouvant correspondre à des micro-poutres.

Dans un tel micro-dispositif 100, l'élément mobile intermédiaire 304 forme un étage de suspension intermédiaire permettant d'isoler les éléments mobiles 111, 113 vis-à-vis des mouvements ou vibrations extérieures subies par le micro-dispositif 100, et donc par la partie fixe 302.

Un exemple de procédé de réalisation d'un tel micro-dispositif 100 est décrit en lien avec les figures 9A à 9K.

Comme dans les précédents modes de réalisation, le procédé est mis en œuvre à partir d'un empilement de couches comportant la couche support 102, la couche sacrificielle 108 et la première couche de matériau 104 (figure 9A).

Au cours d'une même étape de gravure, les tranchées d'isolation électrique 136, les trous de libération 140 ainsi que les portions 112, 126 des éléments mobiles 111, 113 sont ensuite réalisés dans la première couche 104 (figure 9B). Cette étape de gravure délimite également, au sein de la première couche 104, des parties 312 de l'élément mobile intermédiaire 304 vis-à-vis de la partie fixe 302 destinée à rester solidaire de la couche support 102. Une partie des éléments de maintien 306, 308 et 310 peuvent également être réalisés.

La deuxième couche de matériau 106 est ensuite réalisée sur la première couche 104, ici via un report de substrat de type semi-conducteur sur isolant et via la couche intermédiaire 110 (figure 9C).

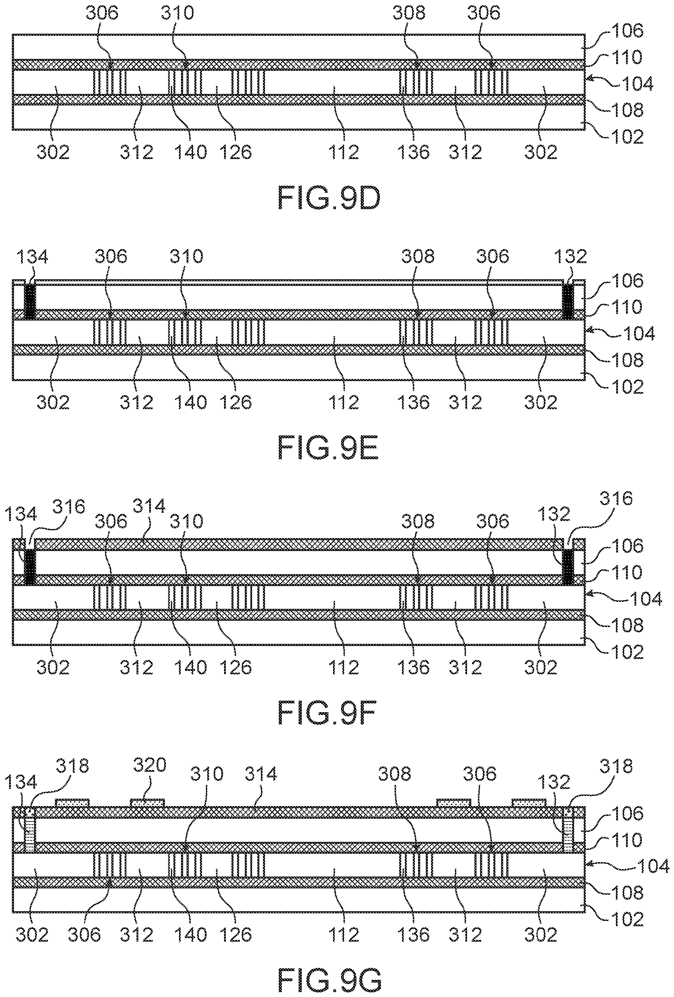

Comme représenté sur la figure 9D, les couches 142 et 144 sont retirées. La deuxième couche 106 est ici également amincie à l'épaisseur souhaitée.

Comme dans les précédents modes de réalisation, les deux couches 104 et 106 peuvent être reliées électriquement en réalisant un ou plusieurs vias d'interconnexion 132, 134 entre ces deux couches (figure 9E).

Une couche diélectrique 314 est ensuite formée sur la deuxième couche 106. Des ouvertures 316 sont formées à travers cette couche diélectrique 314 en regard des vias 132, 134 (figure 9F).

Une couche électriquement conductrice, par exemple métallique, est ensuite déposée sur la couche diélectrique 314 et dans les ouvertures 316, puis gravée afin de conserver des portions 318 disposées dans les ouvertures 316 formant des contacts électriques reliés aux vias 132, 134, ainsi que des portions 320 destinées à la réalisation ultérieure de cordons de scellement métalliques destinés à assurer une fermeture hermétique d'une première cavité dans laquelle seront disposés les éléments mobiles 112, 114 et d'une deuxième cavité dans laquelle sera disposé l'élément mobile intermédiaire 304 (figure 9G).

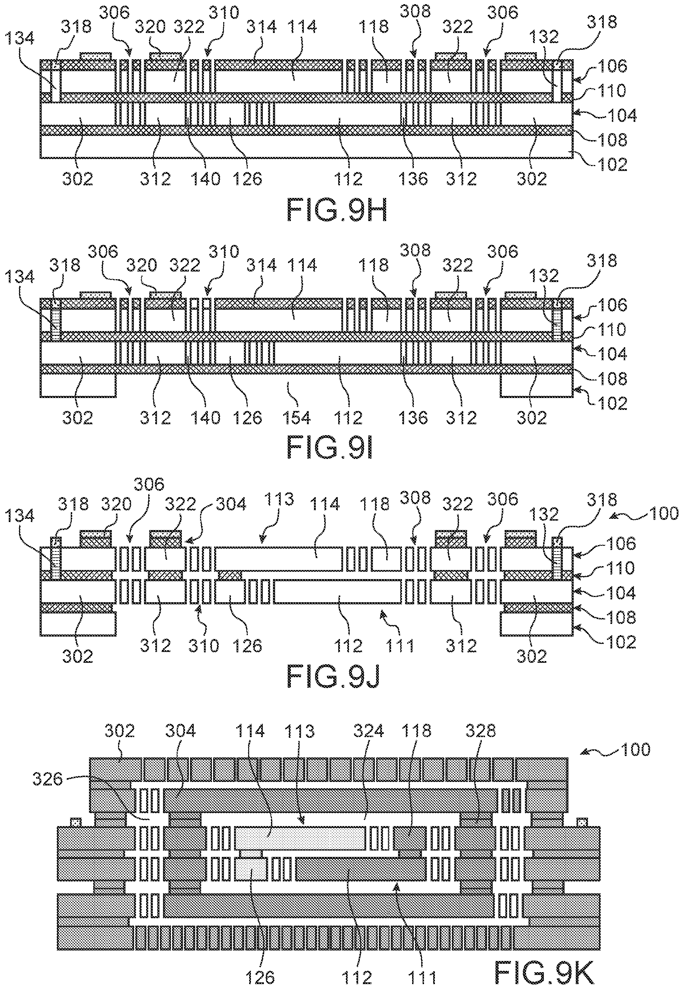

Les couches 314 et 106 sont ensuite gravées afin de définir les portions 114 et 118 (et également les autres éléments de maintien, de détection, etc.) ainsi que les éventuelles tranchées d'isolation 146, les trous de libération 152 et définir également d'autres parties 322 de l'élément mobile intermédiaire 304 (figure 9H).

La couche support 102 est ensuite gravée afin de former un accès 154 aux parties de la couche sacrificielle 108 se trouvant au niveau de la partie du micro-dispositif 100 comprenant les portions 112, 126 ainsi que celle au niveau de laquelle se trouve l'élément mobile intermédiaire 304 (figure 9I).

Les différents éléments mobiles du micro-dispositif 100 sont alors libérés en gravant les parties des couches 108 et 110 auxquelles ces éléments mobiles 111, 113 et 304 sont liés (figure 9J). Les parties de la couche 314 non recouvertes par les portions métalliques 320 sont également gravées.

La structure ainsi obtenue en figure 9J peut aussi être encapsulée pour former le micro-dispositif 100 tel que représenté sur la figure 9K, sur laquelle les éléments de détection comprenant les éléments mobiles 111, 113 sont encapsulés dans une cavité 324 délimitée notamment par l'élément mobile intermédiaire 304. L'élément mobile intermédiaire 304 est lui-même encapsulé dans une cavité 326 qui inclue la cavité 324. Les cavités 324, 326 sont par exemple isolées hermétiquement l'une de l'autre grâce au cordon de scellement 328 les séparant. L'élément mobile intermédiaire 304 forme ici un cadre mobile suspendu au cadre fixe formé par la partie fixe 302.

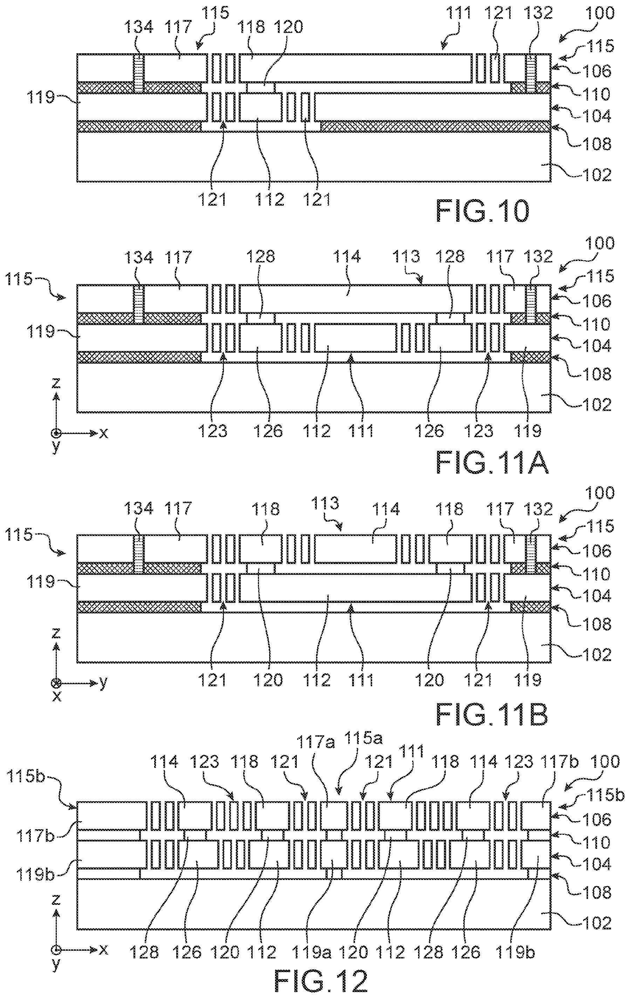

Dans les modes de réalisation précédemment décrits, le micro-dispositif 100 comporte plusieurs éléments mobiles. Selon un exemple hors du cadre de l'invention représenté sur la figure 10, le micro-dispositif 100 comporte un seul élément mobile 111 formé par la première portion 112 de la première couche 104 et la deuxième portion 118 de la deuxième couche 106. Les portions 112 et 118 sont reliées, ou solidarisées, l'une à l'autre par l'intermédiaire de la portion 120 de la couche intermédiaire 110.

Cet élément mobile 111 forme une masse mobile apte à se déplacer par rapport à la partie fixe 115 du micro-dispositif 100. Cette partie fixe 115 comporte les portions 117 et 119 des premières et deuxièmes couches 104, 106 auxquelles est suspendu l'élément mobile 111 par l'intermédiaire des premiers moyens de suspension 121 formés de chaque côté de l'élément mobile 111.

Les différentes variantes de réalisation décrites pour les précédents modes de réalisation peuvent s'appliquer au micro-dispositif 100 représenté sur la figure 10.

En variante du micro-dispositif 100 représenté sur la figure 10, il est possible que le premier élément mobile 111 est une géométrie proche ou similaire de celle du premier élément mobile 111 du micro-dispositif 100 précédemment décrit en lien avec la figure 1.

Pour la réalisation du micro-dispositif 100 représenté sur la figure 10, un procédé similaire à l'un de ceux précédemment décrits peut être mis en œuvre, dans lequel les étapes mises en œuvre réalisent un seul élément mobile.

Le micro-dispositif 100 selon un autre mode de réalisation différent de ceux précédemment décrits est représenté schématiquement selon deux vues différentes sur les figures 11A et 11B.

Dans cet autre mode de réalisation représenté sur les figures 11A et 11B, le micro-dispositif 100 comporte les deux éléments mobiles 111, 113. Le premier élément mobile 111 est formé par la première portion 112 de la première couche 104 et des deuxièmes portions 118 de la deuxième couche 106. Le deuxième élément mobile 113 est formé par la première portion 114 de la première couche 104 et des deuxièmes portions 126 de la première couche 104.

Dans ce micro-dispositif 100, les premier et deuxième éléments mobiles 111, 113 forment des masses mobiles aptes à se déplacer par rapport à la partie fixe 115 du micro-dispositif 100 et également l'une par rapport à l'autre. Comme précédemment, la partie fixe 115 comporte les portions 117, 119 des première et deuxième couches 104, 106 auxquelles sont suspendus les éléments mobiles 111, 113 par l'intermédiaire respectivement de premiers et deuxièmes moyens de suspension 121, 123.

Dans ce mode de réalisation, les deux éléments mobiles 111, 113 sont disposés de manière imbriquée l'un par rapport à l'autre.

En outre, dans la configuration représentée sur les figures 11A et 11B, les centres de gravité des premier et deuxième éléments mobiles 111, 113 sont alignés l'un au-dessus de l'autre selon un axe sensiblement perpendiculaire à des faces principales des première et deuxième couches de matériau 104, 106.

Un micro-dispositif 100 selon un autre mode de réalisation différent de ceux précédemment décrits est représenté sur la figure 12.

Dans cet autre mode de réalisation, les premier et deuxième éléments mobiles 111, 113 sont réalisés de manière concentrique l'un par rapport à l'autre. Ainsi, sur la figure 12, le premier élément mobile 111 comporte des portions 112, 118 des couches 104, 106 qui entourent au moins partiellement des portions 117a, 119a des couches 104, 106 qui forment une partie fixe 115a à laquelle le premier élément mobile 111 est suspendu par l'intermédiaire des premiers moyens de suspension 121. Le deuxième élément mobile 113 est formé par des portions 114, 126 des couches 104, 106 disposées autour des portions 112, 118 du premier élément mobile 111 telles que le premier élément mobile 111 soit entouré au moins partiellement par le deuxième élément mobile 113. Le deuxième élément mobile 113 est suspendu à une autre partie fixe 115b, formée par des portions 117b, 119b disposées autour du deuxième élément mobile 113, par des deuxièmes moyens de suspension 123.

Vue de dessus, chacun des éléments mobiles 111, 113 peut avoir une forme d'anneau ou de couronne. En outre, dans le plan principal des couches 104, 106 (plan (X,Y)), la section des anneaux ou couronnes formés par les éléments mobiles 111, 113 peut être circulaire ou bien polygonale (carrée, hexagonale, etc.).

Selon encore une autre variante de réalisation, le micro-dispositif 100 peut comporter le premier élément mobile 111 ou le deuxième élément mobile 113 tel que décrit dans l'un des précédents modes de réalisation, et un autre élément mobile qui comporte une ou plusieurs portions de matériaux d'une seule des couches de matériau 104, 106 (contrairement aux précédents modes de réalisation décrits dans lesquels chaque élément mobile comporte au moins deux portions de matériau issues d'au moins deux couches de matériau distinctes).

## Revendications

1. Micro-dispositif (100) comprenant au moins :
- une première couche de matériau (104),
- une deuxième couche de matériau (106),
- une partie fixe (115, 302),
- un premier élément mobile (111) comprenant au moins une première portion (112) de la première couche de matériau (104) et au moins une deuxième portion (118) de la deuxième couche de matériau (106),
- un deuxième élément mobile (113) comprenant au moins une première portion (114) de la deuxième couche de matériau (106) et au moins une deuxième portion (126) de la première couche de matériau (104),
- des premiers moyens de suspension (121) formés dans la première couche de matériau (104) et/ou dans la deuxième couche de matériau (106),
- des deuxièmes moyens de suspension (123) formés dans la première couche de matériau (104) et/ou dans la deuxième couche de matériau (106),
et dans lequel :
- les premier et deuxième éléments mobiles (111, 113) sont aptes à se déplacer l'un par rapport à l'autre et par rapport à la partie fixe (115, 302),
- les première et deuxième couches de matériau (104, 106) sont disposées l'une au-dessus de l'autre,
- la première portion (112) de la première couche de matériau (104) est solidaire de la deuxième portion (118) de la deuxième couche de matériau (106),
- le premier élément mobile (111) est suspendu à la partie fixe (115, 302) par les premiers moyens de suspension (121),
- le deuxième élément mobile (113) est suspendu à la partie fixe (115, 302) par les deuxièmes moyens de suspension (123),
- la première portion (114) de la deuxième couche de matériau (106) est solidaire de la deuxième portion (126) de la première couche de matériau (104), **caractérisé en ce que**
- les premier et deuxième éléments mobiles (111, 113) sont aptes à se déplacer sensiblement en opposition de phase l'un par rapport à l'autre lorsque le micro-dispositif est soumis à une action extérieure,
- les centres de gravité des premier et deuxième éléments mobiles (111, 113) sont alignés l'un au-dessus de l'autre selon un axe sensiblement perpendiculaire à des faces principales des première et deuxième couches de matériau (104, 106).

2. Micro-dispositif (100) selon la revendication 1, dans lequel les premier et deuxième éléments mobiles (111, 113) sont disposés de manière imbriquée et/ou concentrique l'un par rapport à l'autre.

3. Micro-dispositif (100) selon l'une des revendications précédentes, dans lequel la première portion (112) de la première couche de matériau (104) est reliée à la deuxième portion (118) de la deuxième couche de matériau (106) par l'intermédiaire d'au moins une première portion (120) d'une couche intermédiaire (110) disposée entre les première et deuxième couches de matériau (104, 106), et/ou dans lequel la première portion (114) de la deuxième couche de matériau (106) est reliée à la deuxième portion (126) de la première couche de matériau (104) par l'intermédiaire d'au moins une deuxième portion (128) de la couche intermédiaire (110).

4. Micro-dispositif (100) selon l'une des revendications précédentes, comportant en outre des éléments de détection et/ou de mesure d'un déplacement du premier élément mobile (111) et/ou du deuxième élément mobile (113) par rapport à la partie fixe (115, 302) et/ou d'un déplacement du premier élément mobile (111) par rapport au deuxième élément mobile (113), et/ou des éléments aptes à déplacer le premier élément mobile (111) et/ou le deuxième élément mobile (113) par rapport à la partie fixe (115, 302) et/ou déplacer le premier élément mobile (111) par rapport au deuxième élément mobile (113).

5. Micro-dispositif (100) selon l'une des revendications précédentes, dans lequel le premier élément mobile (111) et/ou le deuxième élément mobile (113) sont aptes à se déplacer en translation et/ou en rotation par rapport à la partie fixe (115, 302) et/ou l'un par rapport à l'autre.

6. Micro-dispositif (100) selon l'une des revendications précédentes, dans lequel la partie fixe (115, 302) comporte des portions (117, 119) des première et deuxième couches de matériau (104, 106) disposées autour des premier et deuxième éléments mobiles (111, 113) et/ou entourées par les premier et deuxième éléments mobiles (111, 113).

7. Micro-dispositif (100) selon l'une des revendications précédentes, dans lequel la partie fixe (115, 302) comporte une couche support (102) telle que la première couche de matériau (104) soit disposée entre la couche support (102) et la deuxième couche de matériau (106).

8. Micro-dispositif (100) selon l'une des revendications précédentes, comportant en outre au moins un élément mobile intermédiaire (304) suspendu à la partie fixe (302) et apte à se déplacer par rapport à la partie fixe (302), et dans lequel les premier et deuxième éléments mobiles (111, 113) sont suspendus à l'élément mobile intermédiaire (304) et aptes à se déplacer par rapport à l'élément mobile intermédiaire (304) et à la partie fixe (302).

9. Micro-dispositif (100) selon la revendication 8, dans lequel :
- la partie fixe (302) comporte un cadre fixe entourant au moins en partie l'élément mobile intermédiaire (304), et l'élément mobile intermédiaire (304) forme un cadre mobile suspendu au cadre fixe, et/ou
- le micro-dispositif (100) comporte en outre une première cavité (326) dont au moins une partie des parois est formée par la partie fixe (302) et dans laquelle est encapsulé l'élément mobile intermédiaire (304), et une deuxième cavité (324) disposée au sein de la première cavité (326), dont au moins une partie des parois est formée par l'élément mobile intermédiaire (304) et dans laquelle sont encapsulés les premier et deuxième éléments mobiles (111, 113).

10. Procédé de réalisation d'un micro-dispositif (100), comportant au moins :
- gravure d'une première couche de matériau (104) telle qu'au moins une première portion (112) de la première couche de matériau (104) forme une première partie d'au moins un premier élément mobile (111) et qu'au moins une deuxième portion (126) de la première couche de matériau (104) forme une première partie d'au moins un deuxième élément mobile (113),
- réalisation d'une deuxième couche de matériau (106) sur la première couche de matériau (104),
- gravure de la deuxième couche de matériau (106) telle qu'au moins une deuxième portion (118) de la deuxième couche de matériau (106) forme une deuxième partie du premier élément mobile (111) et soit solidaire de la première portion (112) de la première couche de matériau (104) et qu'au moins une première portion (114) de la deuxième couche de matériau (106) forme une deuxième partie du deuxième élément mobile (113) et soit solidaire de la deuxième portion (126) de la première couche de matériau (104),
ces étapes étant mises en œuvre telles que :
- le premier élément mobile (111) soit suspendu à une partie fixe (115, 302) par des premiers moyens de suspension (121) formés dans la première couche de matériau (104) et/ou dans la deuxième couche de matériau (106),
- le deuxième élément mobile (113) soit suspendu à la partie fixe (115, 302) par des deuxièmes moyens de suspension (123) formés dans la première couche de matériau (104) et/ou dans la deuxième couche de matériau (106),
- les premier et deuxième éléments mobiles (111, 113) soient aptes à se déplacer l'un par rapport à l'autre et par rapport à la partie fixe (115, 302), **caractérisé en ce que**
- les premier et deuxième éléments mobiles (111, 113) sont aptes à se déplacer sensiblement en opposition de phase l'un par rapport à l'autre lorsque le micro-dispositif est soumis à une action extérieure,
- les centres de gravité des premier et deuxième éléments mobiles (111, 113) sont alignés l'un au-dessus de l'autre selon un axe sensiblement perpendiculaire à des faces principales des première et deuxième couches de matériau (104, 106).

11. Procédé selon la revendication 10, dans lequel la réalisation de la deuxième couche de matériau (106) sur la première couche de matériau (104) comporte un report de la deuxième couche de matériau (106) sur la première couche de matériau (104) tel qu'une couche intermédiaire (110) soit disposée entre les première et deuxième couches de matériau (104, 106), le procédé comportant en outre, après la gravure de la deuxième couche de matériau (106), une gravure de la couche intermédiaire (110) telle qu'au moins une première portion (120) de la couche intermédiaire (110) relie la première portion (112) de la première couche de matériau (104) à la deuxième portion (118) de la deuxième couche de matériau (106) et, lorsque le deuxième élément mobile (113) est réalisé, qu'au moins une deuxième portion (128) de la couche intermédiaire (110) relie la première portion (114) de la deuxième couche de matériau (106) à la deuxième portion (118) de la première couche de matériau (104).

12. Procédé selon l'une des revendications 10 et 11, dans lequel une couche sacrificielle (108) est disposée entre la première couche de matériau (104) et une couche support (102), le procédé comportant en outre, après la gravure de la deuxième couche de matériau (106), la réalisation d'un accès (154) à la couche sacrificielle (108) à travers la couche support (102) puis une gravure d'une partie de la couche sacrificielle (108) via l'accès (154) formé à travers la couche support (102), libérant au moins la première portion (112) de la première couche de matériau (104) vis-à-vis de la couche support (102).

13. Procédé selon l'une des revendications 10 et 11, dans lequel une couche sacrificielle (108) est disposée entre la première couche de matériau (104) et une couche support (102), le procédé comportant en outre, entre la gravure de la première couche de matériau (104) et la réalisation de la deuxième couche de matériau (106), une gravure d'une première partie de la couche sacrificielle (108) libérant partiellement au moins la première portion (112) de la première couche de matériau (104) vis-à-vis de la couche support (102), et après la gravure de la deuxième couche de matériau (106), une gravure d'une deuxième partie de la couche sacrificielle (108) via des ouvertures (140, 152) formées à travers les première et deuxième couches de matériau (104, 106) lors des précédentes gravures des première et deuxième couches de matériau (104, 106), achevant la libération de la première portion (112) de la première couche de matériau (104) vis-à-vis de la couche support (102).

14. Procédé selon la revendication 13, dans lequel les étapes de gravure des première et deuxième couches de matériau (104, 106) forment des trous de libération (140, 152) traversant les première et deuxième couches de matériau (104, 106) et qui sont alignés les uns au-dessus des autres.

15. Procédé selon la revendication 14, dans lequel l'étape de gravure de la deuxième couche de matériau (106) forme des trous de libération additionnels (162) traversant la deuxième couche de matériau (106).

16. Procédé selon l'une des revendications 10 à 15, dans lequel les étapes de gravure des première et deuxième couches de matériau (104, 106) sont mises en œuvre en utilisant un même système de marques d'alignement disposé au niveau d'un surface arrière d'un support (102) des première et deuxième couches de matériau (104, 106).

## Patentansprüche

1. Mikrovorrichtung (100), die mindestens Folgendes umfasst:
- eine erste Materialschicht (104),
- eine zweite Materialschicht (106),
- einen festen Teil (115, 302),
- ein erstes bewegliches Element (111), das mindestens einen ersten Abschnitt (112) der ersten Materialschicht (104) und mindestens einen zweiten Abschnitt (118) der zweiten Materialschicht (106) umfasst,
- ein zweites bewegliches Element (113), das mindestens einen ersten Abschnitt (114) der zweiten Materialschicht (106) und mindestens einen zweiten Abschnitt (126) der ersten Materialschicht (104) umfasst,
- erste Aufhängungsmittel (121), die in der ersten Materialschicht (104) und/oder in der zweiten Materialschicht (106) ausgebildet sind,
- zweite Aufhängungsmittel (123), die in der ersten Materialschicht (104) und/oder in der zweiten Materialschicht (106) ausgebildet sind,
und wobei:
- das erste und das zweite bewegliche Element (111, 113) dazu ausgelegt sind, sich in Bezug aufeinander und in Bezug auf den festen Teil (115, 302) zu bewegen,
- die erste und die zweite Materialschicht (104, 106) übereinander angeordnet sind,
- der erste Abschnitt (112) der ersten Materialschicht (104) fest mit dem zweiten Abschnitt (118) der zweiten Materialschicht (106) verbunden ist,
- das erste bewegliche Element (111) durch die ersten Aufhängungsmittel (121) am festen Teil (115, 302) aufgehängt ist,
- das zweite bewegliche Element (113) durch die zweiten Aufhängungsmittel (123) am festen Teil (115, 302) aufgehängt ist,
- der erste Abschnitt (114) der zweiten Materialschicht (106) fest mit dem zweiten Abschnitt (126) der ersten Materialschicht (104) verbunden ist,
**dadurch gekennzeichnet, dass**
- das erste und das zweite bewegliche Element (111, 113) dazu ausgelegt sind, sich in Bezug aufeinander im Wesentlichen gegenphasig zu bewegen, wenn die Mikrovorrichtung einer Handlung von außen unterliegt,
- die Schwerpunkte des ersten und des zweiten beweglichen Elements (111, 113) übereinander entlang einer Achse ausgerichtet sind, die im Wesentlichen senkrecht zu den Hauptflächen der ersten und der zweiten Materialschicht (104, 106) verläuft.

2. Mikrovorrichtung (100) nach Anspruch 1, wobei das erste und das zweite bewegliche Element (111, 113) in Bezug aufeinander verschachtelt und/oder konzentrisch angeordnet sind.

3. Mikrovorrichtung (100) nach einem der vorhergehenden Ansprüche, wobei der erste Abschnitt (112) der ersten Materialschicht (104) mit dem zweiten Abschnitt (118) der zweiten Materialschicht (106) über mindestens einen ersten Abschnitt (120) einer Zwischenschicht (110) verbunden ist, die zwischen der ersten und der zweiten Materialschicht (104, 106) angeordnet ist, und/oder wobei der erste Abschnitt (114) der zweiten Materialschicht (106) mit dem zweiten Abschnitt (126) der ersten Materialschicht (104) über mindestens einen zweiten Abschnitt (128) der Zwischenschicht (110) verbunden ist.

4. Mikrovorrichtung (100) nach einem der vorhergehenden Ansprüche, die ferner Elemente zum Erfassen und/oder Messen einer Bewegung des ersten beweglichen Elements (111) und/oder des zweiten beweglichen Elements (113) in Bezug auf den festen Teil (115, 302) und/oder einer Bewegung des ersten beweglichen Elements (111) in Bezug auf das zweite bewegliche Element (113) und/oder Elemente umfasst, die dazu ausgelegt sind, das erste bewegliche Element (111) und/oder das zweite bewegliche Element (113) in Bezug auf den festen Teil (115, 302) zu bewegen und/oder das erste bewegliche Element (111) in Bezug auf das zweite bewegliche Element (113) zu bewegen.

5. Mikrovorrichtung (100) nach einem der vorhergehenden Ansprüche, wobei das erste bewegliche Element (111) und/oder das zweite bewegliche Element (113) dazu ausgelegt ist, sich translatorisch und/oder rotierend in Bezug auf den festen Teil (115, 302) und/oder in Bezug aufeinander zu bewegen.

6. Mikrovorrichtung (100) nach einem der vorhergehenden Ansprüche, wobei der feste Teil (115, 302) Abschnitte (117, 119) der ersten und der zweiten Materialschicht (104, 106) umfasst, die um das erste und das zweite bewegliche Element (111, 113) herum angeordnet und/oder von dem ersten und dem zweiten beweglichen Element (111, 113) umgeben sind.

7. Mikrovorrichtung (100) nach einem der vorhergehenden Ansprüche, wobei der feste Teil (115, 302) eine Trägerschicht (102) umfasst, so dass die erste Materialschicht (104) zwischen der Trägerschicht (102) und der zweiten Materialschicht (106) angeordnet ist.

8. Mikrovorrichtung (100) nach einem der vorhergehenden Ansprüche, die ferner mindestens ein bewegliches Zwischenelement (304) umfasst, das an dem festen Teil (302) aufgehängt und dazu ausgelegt ist, sich in Bezug auf den festen Teil (302) zu bewegen, und wobei das erste und das zweite bewegliche Element (111, 113) an dem beweglichen Zwischenelement (304) aufgehängt und dazu ausgelegt sind, sich in Bezug auf das bewegliche Zwischenelement (304) und den festen Teil (302) zu bewegen.

9. Mikrovorrichtung (100) nach Anspruch 8, wobei:
- der feste Teil (302) einen festen Rahmen umfasst, der mindestens teilweise das bewegliche Zwischenelement (304) umgibt, und das bewegliche Zwischenelement (304) einen beweglichen Rahmen bildet, der am festen Rahmen aufgehängt ist, und/oder
- die Mikrovorrichtung (100) ferner einen ersten Hohlraum (326), bei dem mindestens ein Teil der Wände durch den festen Teil (302) ausgebildet wird und in dem das bewegliche Zwischenelement (304) eingekapselt ist, und einen zweiten Hohlraum (324) umfasst, der in dem ersten Hohlraum (326) angeordnet ist, bei dem mindestens ein Teil der Wände durch das bewegliche Zwischenelement (304) ausgebildet wird und in dem das erste und das zweite bewegliche Element (111, 113) eingekapselt sind.

10. Verfahren zum Herstellen einer Mikrovorrichtung (100), das mindestens Folgendes umfasst:
- Ätzen einer ersten Materialschicht (104), so dass mindestens ein erster Abschnitt (112) der ersten Materialschicht (104) einen ersten Teil von mindestens einem ersten beweglichen Element (111) bildet und mindestens ein zweiter Abschnitt (126) der ersten Materialschicht (104) einen ersten Teil von mindestens einem zweiten beweglichen Element (113) bildet,
- Herstellen einer zweiten Materialschicht (106) auf der ersten Materialschicht (104),
- Ätzen der zweiten Materialschicht (106), so dass mindestens ein zweiter Abschnitt (118) der zweiten Materialschicht (106) einen zweiten Teil des ersten beweglichen Elements (111) bildet und fest mit dem ersten Abschnitt (112) der ersten Materialschicht (104) verbunden ist, und mindestens ein erster Abschnitt (114) der zweiten Materialschicht (106) einen zweiten Teil des zweiten beweglichen Elements (113) bildet und fest mit dem zweiten Abschnitt (126) der ersten Materialschicht (104) verbunden ist,
wobei diese Schritte so implementiert werden, dass:
- das erste bewegliche Element (111) an einem festen Teil (115, 302) durch erste Aufhängungsmittel (121) aufgehängt ist, die in der ersten Materialschicht (104) und/oder in der zweiten Materialschicht (106) ausgebildet sind,
- das zweite bewegliche Element (113) an dem festen Teil (115, 302) durch zweite Aufhängungsmittel (123) aufgehängt ist, die in der ersten Materialschicht (104) und/oder in der zweiten Materialschicht (106) ausgebildet sind,
- das erste und das zweite bewegliche Element (111, 113) dazu ausgelegt sind, sich in Bezug aufeinander und in Bezug auf den festen Teil (115, 302) zu bewegen,
**dadurch gekennzeichnet, dass**
- das erste und das zweite bewegliche Element (111, 113) dazu ausgelegt sind, sich in Bezug aufeinander im Wesentlichen gegenphasig zu bewegen, wenn die Mikrovorrichtung einer Handlung von außen unterliegt,
- die Schwerpunkte des ersten und des zweiten beweglichen Elements (111, 113) übereinander entlang einer Achse ausgerichtet sind, die im Wesentlichen senkrecht zu den Hauptflächen der ersten und der zweiten Materialschicht (104, 106) verläuft.

11. Verfahren nach Anspruch 10, wobei das Herstellen der zweiten Materialschicht (106) auf der ersten Materialschicht (104) ein Übertragen der zweiten Materialschicht (106) auf die erste Materialschicht (104) umfasst, so dass eine Zwischenschicht (110) zwischen der ersten und der zweiten Materialschicht (104, 106) angeordnet wird, wobei das Verfahren nach dem Ätzen der zweiten Materialschicht (106) ferner ein Ätzen der Zwischenschicht (110) umfasst, so dass mindestens ein erster Abschnitt (120) der Zwischenschicht (110) den ersten Abschnitt (112) der ersten Materialschicht (104) mit dem zweiten Abschnitt (118) der zweiten Materialschicht (106) verbindet, und, wenn das zweite bewegliche Element (113) hergestellt wird, mindestens ein zweiter Abschnitt (128) der Zwischenschicht (110) den ersten Abschnitt (114) der zweiten Materialschicht (106) mit dem zweiten Abschnitt (118) der ersten Materialschicht (104) verbindet.

12. Verfahren nach einem der Ansprüche 10 und 11, wobei zwischen der ersten Materialschicht (104) und einer Trägerschicht (102) eine Opferschicht (108) angeordnet wird, wobei das Verfahren nach dem Ätzen der zweiten Materialschicht (106) ferner das Herstellen eines Zugangs (154) zur Opferschicht (108) quer durch die Trägerschicht (102) und dann ein Ätzen eines Teils der Opferschicht (108) über den quer durch die Trägerschicht (102) ausgebildeten Zugang (154) umfasst, wodurch mindestens der erste Abschnitt (112) der ersten Materialschicht (104) gegenüber der Trägerschicht (102) freigesetzt wird.

13. Verfahren nach einem der Ansprüche 10 und 11, wobei zwischen der ersten Materialschicht (104) und einer Trägerschicht (102) eine Opferschicht (108) angeordnet wird, wobei das Verfahren ferner zwischen dem Ätzen der ersten Materialschicht (104) und dem Herstellen der zweiten Materialschicht (106) ein Ätzen eines ersten Teils der Opferschicht (108), wodurch mindestens teilweise der erste Abschnitt (112) der ersten Materialschicht (104) gegenüber der Trägerschicht (102) freigesetzt wird, und nach dem Ätzen der zweiten Materialschicht (106) ein Ätzen eines zweiten Teils der Opferschicht (108) über Öffnungen (140, 152) umfasst, die quer durch die erste und die zweite Materialschicht (104, 106) während der vorherigen Ätzungen der ersten und der zweiten Materialschicht (104, 106) ausgebildet wurden, wodurch das Freisetzen des ersten Abschnitts (112) der ersten Materialschicht (104) gegenüber der Trägerschicht (102) abgeschlossen wird.

14. Verfahren nach Anspruch 13, wobei die Schritte des Ätzens der ersten und der zweiten Materialschicht (104, 106) Freisetzungslöcher (140, 152) bilden, die durch die erste und die zweite Materialschicht (104, 106) verlaufen und übereinander ausgerichtet sind.

15. Verfahren nach Anspruch 14, wobei der Schritt des Ätzens der zweiten Materialschicht (106) zusätzliche Freisetzungslöcher (162) bildet, die durch die zweite Materialschicht (106) verlaufen.

16. Verfahren nach einem der Ansprüche 10 bis 15, wobei die Schritte des Ätzens der ersten und der zweiten Materialschicht (104, 106) unter Verwendung desselben Systems von Ausrichtungsmarkierungen, das an einer hinteren Fläche eines Trägers (102) der ersten und der zweiten Materialschicht (104, 106) angeordnet ist, implementiert werden.

## Claims

1. Microdevice (100) comprising at least:
- a first layer of material (104),
- a second layer of material (106),
- a fixed portion (115, 302),
- a first mobile element (111) comprising at least a first portion (112) of the first layer of material (104) and at least a second portion (118) of the second layer of material (106),
- a second mobile element (113) comprising at least a first portion (114) of the second layer of material (106) and at least a second portion (126) of the first layer of material (104),
- first suspension means (121) formed in the first layer of material (104) and/or in the second layer of material (106),
- second suspension means (123) formed in the first layer of material (104) and/or in the second layer of material (106),
and wherein:
- the first and second mobile elements (111, 113) are capable of moving with respect to one another and with respect to the fixed portion (115, 302),
- the first and second layers of material (104, 106) are arranged one above the other,
- the first portion (112) of the first layer of material (104) is rigidly connected to the second portion (118) of the second layer of material (106),
- the first mobile element (111) is suspended from the fixed portion (115, 302) by the first suspension means (121),
- the second mobile element (113) is suspended from the fixed portion (115, 302) by the second suspension means (123),
- the first portion (114) of the second layer of material (106) is rigidly connected to the second portion (126) of the first layer of material (104),
**characterized in that**: the first and second mobile elements (111, 113) are capable of moving substantially in phase opposition with respect to one another when the device is subjected to an external force,
- the centres of gravity of the first and second mobile elements (111, 113) are aligned one above the other according to an axis substantially perpendicular to main faces of the first and second layers of material (104, 106).

2. Microdevice (100) according to claim 1, wherein the first and second mobile elements (111, 113) are arranged in an interlocking and/or concentric manner with respect to one another.

3. Microdevice (100) according to one of the previous claims, wherein the first portion (112) of the first layer of material (104) is connected to the second portion (118) of the second layer of material (106) by means of at least a first portion (120) of an intermediate layer (110) arranged between the first and second layers of material (104, 106), and/or wherein the first portion (114) of the second layer of material (106) is connected to the second portion (126) of the first layer of material (104) by means of at least a second portion (128) of the intermediate layer (110).

4. Microdevice (100) according to one of the previous claims, further comprising elements for detection and/or measurement of a movement of the first mobile element (111) and/or of the second mobile element (113) with respect to the fixed portion (115, 302) and/or of a movement of the first mobile element (111) with respect to the second mobile element (113), and/or elements capable of moving the first mobile element (111) and/or the second mobile element (113) with respect to the fixed portion (115, 302) and/or moving the first mobile element (111) with respect to the second mobile element (113).

5. Microdevice (100) according to one of the previous claims, wherein the first mobile element (111) and/or the second mobile element (113) are capable of moving in translation and/or in rotation with respect to the fixed portion (115, 302) and/or with respect to one another.

6. Microdevice (100) according to one of the previous claims, wherein the fixed portion (115, 302) comprises portions (117, 119) of the first and second layers of material (104, 106) arranged around the first and second mobile elements (111, 113) and/or surrounded by the first and second mobile elements (111, 113).

7. Microdevice (100) according to one of the previous claims, wherein the fixed portion (115, 302) comprises a support layer (102) such that the first layer of material (104) is arranged between the support layer (102) and the second layer of material (106).

8. Microdevice (100) according to one of the previous claims, further comprising at least one intermediate mobile element (304) suspended from the fixed portion (302) and capable of moving with respect to the fixed portion (302), and wherein the first and second mobile elements (111, 113) are suspended from the intermediate mobile element (304) and capable of moving with respect to the intermediate mobile element (304) and the fixed portion (302).

9. Microdevice (100) according to claim 8, wherein:
- the fixed portion (302) comprises a fixed frame at least partially surrounding the intermediate mobile element (304), and the intermediate mobile element (304) forms a mobile frame suspended from the fixed frame, and/or
- the microdevice (100) further comprises a first cavity (326), at least a portion of the walls of which is formed by the fixed portion (302) and in which the intermediate mobile element (304) is encapsulated, and a second cavity (324) arranged in the first cavity (326), at least a portion of the walls of which is formed by the intermediate mobile element (304) and in which the first and second mobile elements (111, 113) are encapsulated.

10. Method for fabricating a microdevice (100), comprising at least:
- etching of a first layer of material (104) such that at least a first portion (112) of the first layer of material (104) forms a first portion of at least a first mobile element (111) and at least a second portion (126) of the first layer of material (104) forms a first portion of at least a second mobile element (113),
- fabrication of a second layer of material (106) on the first layer of material (104),
- etching of the second layer of material (106) such that at least a second portion (118) of the second layer of material (106) forms a second portion of the first mobile element (111) and is rigidly connected to the first portion (112) of the first layer of material (104) and at least a first portion (114) of the second layer of material (106) forms a second portion of the second mobile element (113) and is rigidly connected to the second portion (126) of the first layer of material (104),
these steps being implemented such that:
- the first mobile element (111) is suspended from a fixed portion (115, 302) by first suspension means (121) formed in the first layer of material (104) and/or in the second layer of material (106),
- the second mobile element (113) is suspended from the fixed portion (115, 302) by second suspension means (123) formed in the first layer of material (103) and/or in the second layer of material (106),
- the first and second mobile elements (111, 113) are capable of moving with respect to one another and with respect to the fixed portion (115, 302),
**characterized in that**: the first and second mobile elements (111, 113) are capable of moving substantially in phase opposition with respect to one another when the device is subjected to an external force,
- the centres of gravity of the first and second mobile elements (111, 113) are aligned one above the other according to an axis substantially perpendicular to main faces of the first and second layers of material (104, 106).

11. Method according to claim 10, wherein the fabrication of the second layer of material (106) on the first layer of material (104) comprises a transfer of the second layer of material (106) onto the first layer of material (104) such that an intermediate layer (110) is arranged between the first and second layers of material (104, 106), the method further comprising, after the etching of the second layer of material (106), an etching of the intermediate layer (110) such that at least a first portion (120) of the intermediate layer (110) connects the first portion (112) of the first layer of material (104) to the second portion (118) of the second layer of material (106) and, when the second mobile element (113) is made, at least a second portion (128) of the intermediate layer (110) connects the first portion (114) of the second layer of material (106) to the second portion (118) of the first layer of material (104).

12. Method according to one of claims 10 and 11, wherein a sacrificial layer (108) is arranged between the first layer of material (104) and a support layer (102), the method further comprising, after the etching of the second layer of material (106), the fabrication of an access (154) to the sacrificial layer (108) through the support layer (102) then an etching of a portion of the sacrificial layer (108) via the access (154) formed through the support layer (102), releasing at least the first portion (112) of the first layer of material (104) with respect to the support layer (102).

13. Method according to one of claims 10 and 11, wherein a sacrificial layer (108) is arranged between the first layer of material (104) and a support layer (102), the method further comprising, between the etching of the first layer of material (104) and the fabrication of the second layer of material (106), an etching of a first portion of the sacrificial layer (108) partially releasing at least the first portion (112) of the first layer of material (104) with respect to the support layer (102), and after the etching of the second layer of material (106), an etching of a second portion of the sacrificial layer (108) via openings (140, 152) formed through the first and second layers of material (104, 106) during the previous etchings of the first and second layers of material (104, 106), completing the releasing of the first portion (112) of the first layer of material (104) with respect to the support layer (102).

14. Method according to claim 13, wherein the steps of etching of the first and second layers of material (104, 106) form releasing holes (140, 152) passing through the first and second layers of material (104, 106) and which are aligned above each other.

15. Method according to claim 14, wherein the step of etching of the second layer of material (106) forms additional releasing holes (162) passing through the second layer of material (106).

16. Method according to one of claims 10 to 15, wherein the steps of etching of the first and second layers of material (104, 106) are implemented while using the same system of alignment marks arranged at a rear surface of a support (102) of the first and second layers of material (104, 106).
